# FASCICULE DE BREVET EUROPEEN

(11) **EP 2 754 154 B1**
(45) Date de publication et mention de la délivrance du brevet: **22.06.2016**
(21) Numéro de dépôt: 12756211.4
(22) Date de dépôt: 10.09.2012
(51) Int. Cl.: G11C 13/00, H01L 27/24

(54) **PROCÉDÉS DE RÉALISATION ET DE PRÉPROGRAMMATION D'UNE MÉMOIRE RESISTIVE NON VOLATILE A CHANGEMENT DE PHASE**
VERFAHREN ZUR HERSTELLUNG UND VORPROGRAMMIERUNG EINES NICHTFLÜCHTIGEN RESISTIVEN PHASENWECHSELSPEICHERS
METHODS FOR PRODUCING AND PREPROGRAMMING A NON-VOLATILE RESISTIVE PHASE-CHANGE MEMORY

(30) Priorité: 09.09.2011 FR 1158031; 06.04.2012 FR 1253212
(43) Date de publication de la demande: 16.07.2014
(73) Titulaire: Commissariat à l'Énergie Atomique et aux Énergies Alternatives, 75015 Paris (FR)
(72) Inventeur: PERNIOLA, Luca, F-38360 Noyarey (FR)
(74) Mandataire: Hautier, Nicolas
(86) Numéro de dépôt international: PCT/EP2012/067614
(87) Numéro de publication internationale: WO 2013/037720

(56) Documents cités:
- US-A1- 2008 149 912
- US-A1- 2009 003 034
- US-A1- 2009 057 644
- US-A1- 2009 302 293

## Description

### DOMAINE TECHNIQUE DE L'INVENTION

La présente invention concerne, en général, les mémoires résistives non volatiles utilisant un matériau dont on fait varier la résistivité sous l'effet de la chaleur, et plus particulièrement, une mémoire résistive pouvant être utilisée dans le cadre d'un processus industriel de fabrication de systèmes embarqués où il est très avantageux de pouvoir la préprogrammer sans que les informations stockées puissent être affectées par les opérations qui suivent, notamment les opérations d'assemblage thermiques comprenant des étapes de soudage ou de brasage par refusion des composants.

### ÉTAT DE LA TECHNIQUE

Les systèmes embarqués informatisés font toujours très largement appel, en plus des éléments électroniques, optiques ou mécaniques propres à chaque système, à l'utilisation de microprocesseurs ou de microcontrôleurs et aux mémoires électroniques nécessaires pour assurer leur fonctionnement. Typiquement, tous les composants constituant un système embarqué sont assemblés sur un ou plusieurs circuits imprimés ou cartes électroniques souvent aussi désignés par leur vocable anglais de PCB, c'est-à-dire « printed circuit board ». L'assemblage est généralement automatisé dans une chaîne de fabrication. Les composants électroniques se présentent le plus souvent sous la forme de composants destinés à être montés en surface (sans broches traversantes). Ils sont alors simplement posés sur le circuit imprimé par une machine de placement. Préalablement, un dépôt d'une pâte de soudage ou de brasage sur les terminaisons des composants et/ou celles du circuit imprimés aura été effectué. On fait ensuite passer le circuit imprimé sur lequel les composants ont été placés dans un four de chauffage, typiquement un four dit tunnel où le gradient de température est réglé pour faire fondre la pâte déposée qui assure, après refroidissement, une fixation mécanique des composants et un excellent contact électrique. Cette opération standard de fabrication d'un circuit imprimé est qualifiée de soudage ou brasage par refusion ou encore, dans la littérature technique en anglais, de « solder reflow ».

Presque toujours, une partie au moins des mémoires constituant un système embarqué est de type non volatile. Par exemple, pour pouvoir y stocker de façon permanente le code opérationnel, généralement appelé microcode, du ou des microprocesseurs ou microcontrôleurs qui servent à réaliser la fonction pour laquelle le système embarqué a été conçu. Il est alors de pratique courante que le processus de fabrication demande que la partie non volatile des mémoires puisse être programmée avant leur montage sur le circuit imprimé. Un avantage très important de cette façon de faire est qu'on peut alors, par exemple, préprogrammer dans la partie non volatile un code spécifique destiné à tester le circuit imprimé dès après assemblage de façon à vérifier son intégrité. Un autre exemple d'avantage lié à la possibilité de pouvoir préprogrammer les mémoires non volatiles concerne les cartes à puce sécurisées souvent désignées par leur vocable anglais de « secure smart cards ». Les émetteurs de telles cartes, par exemple les banques, préfèrent de beaucoup que les données confidentielles qu'elles contiennent puissent y être introduites avant assemblage afin de ne pas avoir à contrôler la distribution de ces informations sensibles au-delà de la chaîne de fabrication.

Si le code opérationnel ou les données fonctionnelles que doivent contenir une mémoire non volatile n'ont pas été préprogrammés ils devront alors pouvoir être chargés in situ, c'est-à-dire dans la mémoire non volatile après qu'elle a été assemblée et interconnectée avec les autres composants sur le circuit imprimé. Des moyens ont été développés depuis longtemps par l'industrie de la microélectronique pour assurer cette fonction après assemblage. Une pratique courante est d'utiliser les circuits de tests qui sont contenus dans la quasi-totalité des circuits développés par cette industrie notamment les circuits dits JTAG, acronyme de l'anglais « Joint Test Action Group » qui désigne un groupe de travail qui a permis de définir une stratégie et des moyens de test des circuits imprimés dès le milieu des années 80 afin de pouvoir s'assurer, après fabrication, du bon fonctionnement de circuits de plus en plus complexes. Devenu un standard, les circuits JTAG permettent d'accéder individuellement aux composants assemblés sur un circuit imprimé à travers une interface série spécialisée qui peut aussi permettre une programmation in situ de la partie mémoire non volatile. La vitesse d'accès intrinsèquement faible et la bande passante disponible limitée de cette méthode font que le chargement du code est une opération qui peut prendre beaucoup de temps et ralentir la chaîne de fabrication.

D'autres moyens ont été conçus pour la programmation in situ de la partie non volatile des mémoires qui ont leurs propres inconvénients comme de nécessiter des points de connexion spécialisés qui n'auront aucune utilité fonctionnelle et/où une interface dédiée à cette fonction pour permettre d'une part, l'écriture du code dans la partie mémoire non volatile, et d'autre part, le contrôle des autres composants afin qu'ils puissent être inhibés pour ne pas interférer avec le chargement du code. Ceci ne manque pas de compliquer grandement la conception du système embarqué et nécessite aussi généralement le développement d'un outil de programmation spécialisé pour le chargement du code après assemblage dans la ligne de fabrication.

Chaque fois que c'est possible on préfère donc charger tout le code nécessaire, c'est-à-dire non seulement le code de test mais aussi le code fonctionnel, avant assemblage. Ceci évite d'avoir recours à une programmation in situ avec tous les inconvénients brièvement mentionnés ci-dessus.

Les mémoires non volatiles utilisées actuellement sont essentiellement des mémoires dites Flash dans lesquelles chaque point mémoire est un transistor métal-oxyde-semiconducteur (MOS) possédant une grille flottante dans lequel on piège des porteurs. La programmation de ces mémoires se fait en appliquant sur les électrodes des tensions plus élevées que celles utilisées pour leur lecture. Ces tensions permettent d'amener dans la grille flottante des charges, ou à les évacuer, afin de modifier de façon permanente, en lecture, le seuil de conduction du transistor pour pouvoir y stocker au moins deux niveaux électriques différents c'est-à-dire un bit d'information. Le piégeage et l'évacuation des porteurs se fait à travers la couche d'oxyde très mince formant la grille du transistor MOS en mettant en oeuvre des effets quantiques du type effet tunnel ou électron chaud. Ce type de stockage non volatile n'est pas particulièrement affecté par la température. Les mémoires Flash supportent très bien la programmation avant assemblage. Leur contenu n'est pas altéré par l'opération de soudage par refusion décrite précédemment dans laquelle, typiquement, la température maximum atteinte est de l'ordre de 245°C pendant une période de temps de 10 à 40 secondes pour les pâtes de soudage contenant du plomb. L'emploi de pâtes sans plomb, maintenant requis pour leur caractère non polluant, augmente la température maximum jusqu'à 260° C ce qui reste sans effet négatif sur la rétention des données préprogrammées dans ce type de mémoire. L'inconvénient principal de ces mémoires est que leur programmation nécessite, comme on l'a vu ci-dessus, de devoir appliquer des tensions et courants importants pour transférer des charges dans ou depuis la grille flottante. Leur écriture est une opération relativement lente et compliquée qui peut avoir à se faire, en fonction de leur structure interne de type dit ET ou OU, sur des blocks de cellules qui doivent être effacés avant d'être réécrits avec les nouvelles données.

C'est pourquoi les mémoires non volatiles de type Flash tendent maintenant à être remplacées par des mémoires résistives utilisant un matériau à changement de phase dont on fait varier réversiblement la structure atomique sous l'effet de la chaleur. Désignées sous l'acronyme de PCM, de l'anglais « phase change memory » c'est-à-dire «mémoire à changement de phase » ces mémoires sont préférées pour le développement de nouveaux produits aux mémoires Flash car elles sont intrinsèquement plus denses et leur écriture beaucoup plus simple et rapide que les mémoires Flash. Typiquement, le matériau à changement de phase utilisé est un chalcogénure et notamment un alliage de germanium (Ge), d'antimoine (Sb) et de tellure (Te) connu sous l'acronyme de GST. Conçues pour opérer à des températures jusqu'à 85°C pendant 10 ans les mémoires PCM sont intrinsèquement, du fait même de leur principe de fonctionnement très brièvement exposé ci-dessus, directement sensibles à la température de l'environnement dans lequel elles doivent fonctionner. Le temps de rétention diminue très rapidement en fonction de la température à laquelle elles sont soumises. D'une durée de 10 ans à 85°C le temps de rétention tombe typiquement à 10 heures à 125°C, à 10 secondes à 165° C et enfin à 10 microsecondes à 225°C. Clairement, les mémoires résistives de type PCM ne peuvent donc être utilement préprogrammées avant assemblage puisque les informations stockées seront alors perdues lors de la phase de soudage par refusion où des températures jusqu'à 260°C pourront être appliquées.

US 2009/302293 A divulgue un procédé comprenant des étapes de fabrication des cellules mémoire dans un dispositif mémoire en formant une couche en un matériau à changement de phase, une étape de préprogrammation du dispositif mémoire consistant en une recristallisation électrique d'une sélection de cellules mémoire, et une étape d'assemblage du dispositif mémoire préprogrammé dans le système.

Il serait particulièrement avantageux de disposer de cellules mémoires permettant une grande densité d'intégration, une écriture rapide et qui seraient aussi capables de retenir leur information à des températures relativement élevées.

La présente invention vise à répondre à cet objectif.

Un autre objectif de l'invention est de proposer une solution pour permettre à une cellule mémoire de ne pas perdre, lors d'une opération d'assemblage, une programmation effectuée au préalable.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Un aspect de la présente invention concerne un procédé de réalisation d'un système comprenant au moins un dispositif mémoire incluant une pluralité de cellules mémoire non volatiles comprenant chacune un matériau à changement de phase configuré pour changer réversiblement d'état entre au moins un état amorphe et un état cristallin présentant des résistances électriques différentes, caractérisé en ce qu'il comprend des étapes de fabrication des cellules mémoire, ces étapes de fabrication comprenant la formation d'une couche en un matériau à changement de phase présentant un état amorphe originel à l'issue des étapes de fabrication des cellules mémoire, ledit procédé de réalisation du système embarqué comprenant, après les étapes de fabrication des cellules mémoire, au moins les étapes suivantes:
- une étape de préprogrammation du dispositif mémoire consistant en une recristallisation électrique d'une sélection de cellules mémoire dont le matériau à changement de phase est dans l'état amorphe originel;
- une étape d'assemblage du dispositif mémoire préprogrammé dans le système au cours duquel le dispositif est soumis à un stress thermique, par exemple une température comprise entre 240°C et 300°C.
Avantageusement, cette température à laquelle est soumis le dispositif mémoire lors de l'étape d'assemblage est donc inférieure à la température du BEOL, typiquement compris entre 350°C et 450°C.

De manière avantageuse mais non limitative, la couche en un matériau à changement de phase est faite d'un alliage de germanium (Ge) et de tellure (Te) et éventuellement d'antimoine (Sb) additionné de carbone (C) ou d'indium (In). De manière avantageuse mais non limitative, la couche en un matériau à changement de phase est couverte par une couche de titane (Ti) dont l'épaisseur est comprise entre 3 et 10 nanomètres.
De manière avantageuse mais non limitative, on choisi le matériau à changement de phase de manière à ce que la résistance des cellules mémoire dont le matériau à changement de phase est dans l'état amorphe originel est, après l'étape d'assemblage, au moins 1,5 fois et de préférence au moins deux fois supérieure à la résistance des cellules mémoire dont le matériau à changement de phase est dans l'état cristallin. De façon plus générale, il suffit que sur un échantillon de cellules mémoire, la résistance la plus faible des cellules de cet échantillon se trouvant dans l'état amorphe originel soit, après l'étape d'assemblage, au moins 1,5 fois et de préférence au moins deux fois supérieure à la résistance la plus forte des cellules de cet échantillon se trouvant dans l'état cristallin. Autrement dit les distributions des résistances des cellules mémoire dans l'état amorphe originel et des cellules mémoire dans l'état cristallin, après l'étape d'assemblage, doivent présenter une différence d'au moins un facteur 1,5 et préférentiellement d'au moins un facteur deux. De préférence ce facteur est supérieur ou égal à cinq et encore plus préférentiellement supérieur ou égal à dix.

Selon un mode de réalisation optionnel et avantageux, le matériau à changement de phase est une couche faite d'un alliage de germanium (Ge), d'antimoine (Sb) et de tellure (Te) ou d'un alliage de germanium (Ge) et de tellure (Te), l'alliage étant additionné de carbone (C) dans lequel la proportion de carbone (C) dans l'alliage est comprise entre 1% et 25%. Selon un autre mode de réalisation optionnel et avantageux, le matériau à changement de phase est une couche (20) faite d'un alliage de germanium (Ge), d'antimoine (Sb) et de tellure (Te) ou d'un alliage de germanium (Ge) et de tellure (Te), l'alliage étant additionné d'indium (In), dans lequel la proportion d'indium (In) dans l'alliage est comprise entre 1% et 25%. Avantageusement la couche matériau à changement de phase est couverte par une couche de titane (Ti) dont l'épaisseur est comprise entre 3 et 10 nanomètres.

Il s'est avéré, de façon inattendue, que la phase amorphe de cet alliage présentant une addition spécifique de carbone ou d'indium et associé à la couche de titane présente une stabilité significativement améliorée face aux élévations de température. En particulier, cette phase amorphe n'est pas altérée par les étapes postérieures de fabrication d'un dispositif incluant la cellule mémoire, quand bien même ces étapes comportent des refusions thermiques, brasages ou soudages. En outre, l'invention bénéficie des avantages liés aux cellules mémoire à changement de phase en termes de temps d'écriture.

De manière générale, l'état amorphe originel est l'état, au moins en partie amorphe et de préférence complètement amorphe, qui est obtenu à l'issue du procédé de fabrication des cellules mémoire et qui n'a été altéré par aucun passage de courant de programmation.

Facultativement, l'invention peut comprendre au moins l'une quelconque des caractéristiques énoncées ci-dessous :
Avantageusement, la proportion de carbone (C) ou d'indium (In) dans l'alliage est comprise entre 3 et 25 % et de préférence entre 5 et 20 %.

Avantageusement, le matériau à changement de phase est une couche faite d'un alliage de germanium (Ge), de tellure (Te) additionné de carbone (C), la proportion de carbone (C) dans l'alliage étant comprise entre 5 et 20 %.

Avantageusement, le matériau à changement de phase est une couche faite d'un alliage de germanium (Ge), de tellure (Te) additionné d'indium (In) et la proportion d'indium (In) dans l'alliage est comprise entre 5 et 20 %.

Avantageusement, l'épaisseur de la couche de titane est comprise entre 3 et 8 nanomètres. Elle est de préférence comprise entre 4 et 6 nanomètres. Encore plus préférentiellement, elle est égale à 5 nanomètres.

Selon une alternative avantageuse, la proportion de carbone (C) ou d'indium (In) dans l'alliage est comprise entre 5 et 20 % et l'épaisseur de la couche de titane est d'environ 5 nanomètres.

De préférence, la couche de titane est en contact avec la couche de matériau à changement de phase.

De préférence, la couche de matériau à changement de phase présente une face inférieure au contact d'un moyen de chauffage ou d'une électrode inférieure et une face supérieure au contact de la couche de titane. De préférence, la couche de titane est au contact d'une électrode supérieure. De préférence, la face inférieure de la couche de matériau à changement de phase est au contact d'un moyen de chauffage disposée au contact de l'électrode inférieure. Alternativement, la face inférieure de la couche de matériau à changement de phase est au contact d'une électrode inférieure formant un moyen de chauffage.

Avantageusement, la température de recristallisation de la couche de matériau à changement de phase associée avec la couche de titane est supérieure à 400°C.

Selon un mode particulier de réalisation, la cellule comprend plusieurs états cristallins et/ou plusieurs états amorphes, chacun de ces états présentant une résistivité différente.

Avantageusement, le dépôt de la couche du matériau à changement de phase est effectué à température ambiante. Avantageusement, le dépôt de la couche de titane est effectué à température ambiante. Le dépôt de ces couches à température ambiante accélère le procédé de fabrication et en réduit le coût. En effet, il n'est alors pas nécessaire d'attendre la stabilisation de la température dans le four avant dépôt.

Avantageusement, le dépôt de la couche du matériau à changement de phase et le dépôt de la couche de titane sont effectués en phase vapeur dans une enceinte confinée à basse pression et à température ambiante.

Selon un autre aspect, la présente invention porte sur un procédé de programmation d'un système comprenant au moins un dispositif intégrant une pluralité de cellules mémoire non volatile comprenant chacune un matériau à changement de phase configuré pour changer réversiblement d'état entre au moins un état amorphe et un état cristallin présentant des résistances électriques différentes, le matériau à changement de phase étant une couche faite d'un alliage de germanium (Ge) et de tellure (Te) additionné de carbone (C) ou d'indium (In) ou étant faite d'un alliage de germanium (Ge), d'antimoine (Sb), de tellure (Te) additionné de carbone (C) ou d'indium (In) dans lequel la proportion de carbone (C) ou d'indium (In) dans l'alliage est comprise entre 1% et 25% en pourcentage molaire; la couche en un matériau à changement de phase étant couverte par une couche de titane (Ti) dont l'épaisseur est comprise entre 3 et 10
nanomètres, la couche en un matériau à changement de phase présentant un état amorphe originel,
ledit procédé de programmation du système comprenant, au moins les étapes suivantes:
- avant assemblage du dispositif préprogrammé dans le système, une étape de préprogrammation du dispositif consistant en une recristallisation électrique d'une sélection de cellules mémoire dont le matériau à changement de phase est dans l'état amorphe originel;
- une étape d'assemblage du dispositif préprogrammé dans le système.

Facultativement, les procédés de l'invention peuvent chacun comprendre au moins l'une quelconque des étapes et caractéristiques énoncées ci-dessous prise seule ou en combinaison.

Avantageusement, l'étape d'assemblage comprend une étape de brasage ou de soudage.

L'étape d'assemblage comprend une étape au cours de laquelle le dispositif subit un stress thermique. Typiquement, un stress thermique comprend l'application d'une température supérieure à 240°C, voire supérieure à 300°C.

De préférence, au cours des étapes de fabrication de cellules mémoires, ces dernières sont soumises à des températures supérieures aux températures imposées lors de l'étape d'assemblage.

Les étapes de fabrication des cellules mémoires comprennent de préférence, l'ensemble des étapes permettant de rendre les cellules opérationnelles. Elles comprennent notamment l'empilement des différentes couches et leurs interconnexions.

Selon un autre mode de réalisation, la présente invention porte sur l'utilisation d'un système comme mémoire à lecture seule et à programmation unique réalisé en mettant en oeuvre l'un quelconque des procédés selon l'invention.

Selon un autre mode de réalisation, la présente invention porte sur l'utilisation comme dispositif mémoire à lecture seule et à programmation unique d'un dispositif intégrant une pluralité de cellules mémoire non volatiles comprenant chacune un matériau à changement de phase configuré pour changer réversiblement d'état entre au moins un état amorphe et un état cristallin présentant des résistances électriques différentes, le matériau à changement de phase étant une couche faite d'un alliage de germanium (Ge) et de tellure (Te) additionné de carbone (C) ou d'indium (In) ou est faite d'un alliage de germanium (Ge), d'antimoine (Sb), de tellure (Te) additionné de carbone (C) ou d'indium (In) dans lequel la proportion de carbone (C) ou d'indium (In) dans l'alliage est comprise entre 1% et 25% ; la couche matériau à changement de phase étant couverte par une couche de titane (Ti) dont l'épaisseur est comprise entre 3 et 10 nanomètres.

Selon un autre mode de réalisation, la présente invention porte sur un système réalisé en mettant en oeuvre l'un quelconque des procédés selon l'invention, le dispositif formant une mémoire à lecture seule (ROM) ou une mémoire programmable à lecture seule (PROM) ou une mémoire programmable une seule fois (OTP).

Facultativement, ce système peut comprendre au moins l'une quelconque des caractéristiques énoncées ci-dessous prise seule ou en combinaison.
- le matériau à changement de phase est une couche faite d'un alliage de germanium (Ge) et de tellure (Te) additionné de carbone (C) ou d'indium (In) ou est faite d'un alliage de germanium (Ge), d'antimoine (Sb), de tellure (Te) additionné de carbone (C) ou d'indium (In) dans lequel la proportion de carbone (C) ou d'indium (In) dans l'alliage est comprise entre 1% et 25% et la couche matériau à changement de phase est couverte par une couche de titane (Ti) dont l'épaisseur est comprise entre 3 et 10 nanomètres.
- une partie des cellules mémoire est dans un état amorphe originel et l'autre partie des cellules mémoire est dans un état cristallin obtenu par cristallisation au moins partielle du matériau à changement de phase à partir de l'état amorphe originel.
- le système comprend des circuits de lecture configurés pour lire les cellules mémoire et différencier les cellules mémoire se trouvant dans un état amorphe originel par rapport aux cellules mémoire se trouvant dans un état cristallin obtenu par cristallisation au moins partielle du matériau à changement de phase à partir de l'état amorphe originel.
- le dispositif du système comprend des circuits d'écriture aptes à amener des cellules mémoire depuis un état amorphe originel dans un état cristallin.
- le dispositif du système comprend des circuits d'écriture des cellules mémoire configurés pour convertir l'état amorphe originel en l'un parmi un état amorphe fonctionnel différent d'un état amorphe originel ou dans un état cristallin fonctionnel différent d'un état cristallin obtenu par cristallisation au moins partielle du matériau à changement de phase à partir de l'état amorphe originel et/ou et configurés pour convertir l'état cristallin obtenu à partir de l'état amorphe originel en l'autre parmi l'état amorphe fonctionnel et l'état cristallin fonctionnel.

L'état originel amorphe est l'état obtenu lors du dépôt. Il demeure inchangé à l'issue des étapes permettant la fabrication des cellules mémoires voire des étapes permettant leur interconnexions. Les propriétés de la couche de matériau à changement de phase sont ainsi conservées même au terme des étapes de BEOL (back end of line) c'est-à-dire celles de fin de ligne de fabrication au cours desquelles on réalise l'interconnexion des cellules.

Le matériau à changement de phase conserve ainsi son état amorphe originel tel que déposé malgré les étapes de fabrication et d'interconnexion des cellules. Sa température de recristallisation est supérieure aux températures habituelles de BEOL. Lors de la préprogrammation, certaines cellules sont volontairement recristallisées. La pluralité de cellules contient alors des informations préprogrammées. Lors de l'étape d'assemblage de la pluralité de cellules mémoire dans un système, les températures auxquelles sont soumises les cellules mémoire ne suffisent pas à modifier l'état des cellules.

De préférence, le matériau à changement de phase est une couche faite d'un alliage de germanium (Ge), de tellure (Te) et de carbone (C) ou d'indium (In) ou faite d'un alliage de germanium (Ge), d'antimoine (Sb), de tellure (Te) et de carbone (C) ou d'indium (In) dans lequel la proportion de carbone (C) ou d'indium (In) est comprise entre 1% et 25% et de préférence comprise entre 3% et 25%. En outre la couche matériau à changement de phase est couverte par une couche de titane (Ti) dont l'épaisseur est comprise entre 3 et 10 nanomètres

Avantageusement, le procédé comprend, après l'étape d'assemblage, une étape de conversion, pour chaque cellule du dispositif mémoire, de l'état amorphe originel ou de l'état cristallin préprogrammé en, respectivement : un état amorphe fonctionnel programmé électriquement à résistance élevé, ou en un état cristallin fonctionnel programmé électriquement à résistance faible.

Avantageusement, les cellules mémoire pourront ainsi être lues et écrites en utilisant des courants moins importants. Avantageusement, les opérations de SET et de RESET seront rendues bien plus rapides.

Alternativement, le procédé comprend, après l'étape d'assemblage, une étape de conversion, pour chaque cellule du dispositif mémoire, de l'état amorphe originel ou de l'état cristallin préprogrammé en, respectivement : en un état cristallin fonctionnel programmé électriquement à résistance faible ou un état amorphe fonctionnel programmé électriquement à résistance élevé.

Dans ce mode de réalisation on inverse les phases cristalline et amorphe lors de l'étape de conversion. Ce mode de réalisation offre les mêmes avantages que le précédent.

De préférence, l'étape de conversion est exécutée sous le contrôle du dispositif mémoire à partir de circuits de lecture et d'écriture des cellules mémoire, les dits circuits de lecture et d'écriture étant pourvus de moyens adaptés pour pouvoir différencier dans chaque cellule : l'état amorphe originel, l'état cristallin préprogrammé, l'état fonctionnel amorphe et l'état fonctionnel cristallin.

De préférence, la recristallisation de l'étape de préprogrammation comprend une programmation électrique également désignée recuit électrique qui s'applique sur une sélection de cellules depuis leur état amorphe originel.

Les cellules présentent, avant la préprogrammation, un état amorphe à haute résistance. Elles présentent, lorsqu'elles sont cristallisées, une faible résistance.

Avantageusement, le procédé comprend en outre une étape de vérification du système embarqué à l'aide d'un code préprogrammé.

Avantageusement, le procédé comprend en outre une étape d'activation d'un code fonctionnel préprogrammé.

Avantageusement le procédé comprend, après les étapes de fabrication des cellules mémoire et avant l'étape d'assemblage du dispositif mémoire préprogrammé dans le système, une étape de montage des cellules mémoire dans un boîtier.

Selon un mode de réalisation, l'étape de montage des cellules mémoire dans le boîtier est effectuée après l'étape de préprogrammation du dispositif mémoire. Ce mode de réalisation est avantageux pour des raisons de sécurisation des données notamment. Selon une alternative, l'étape de montage des cellules mémoire dans le boîtier est effectuée avant l'étape de préprogrammation du dispositif mémoire.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre, à l'aide d'une vue coupe, un exemple d'une cellule mémoire de type PCM utilisée pour réaliser un système selon l'invention.
La FIGURE 2 illustre une caractéristique de l'invention où l'on préprogramme certaines des cellules mémoires d'un dispositif en procédant à une recristallisation locale du matériau à changement de phase depuis son état amorphe originel.
La FIGURE 3 montre des résultats expérimentaux concernant la structure de la cellule mémoire et le matériau à changement de phase utilisés selon un exemple de réalisation de l'invention.
La FIGURE 4 illustre l'opération de SET ou recuit électrique qui est appliqué sur certaines des cellules mémoires en vue de leur préprogrammation avant assemblage.
La FIGURE 5 illustre l'opération de RESET électrique qui est effectuée lors de l'utilisation fonctionnelle du dispositif après qu'il a été assemblé.
La FIGURE 6 illustre une structure de mémoire selon l'invention.
La FIGURE 7 montre les valeurs de résistance observées en mode fonctionnel résultant des opérations de SET et RESET électriques.
La FIGURE 8 décrit un exemple de procédure de mise en oeuvre de l'invention depuis la phase de préprogrammation jusqu'à l'étape d'utilisation fonctionnelle d'un dispositif mémoire PCM selon un exemple de réalisation de l'invention dans un ensemble de type système embarqué informatisé.
La FIGURE 9 illustre de manière simplifiée une mémoire à programmation unique (OTP) que l'on peut obtenir avec l'invention.
La FIGURE 10 est un graphique illustrant les différents niveaux de résistivité que l'on peut obtenir avec une cellule mémoire utilisée pour réaliser un système selon l'invention.
Les FIGURES 11 a à 11d illustrent une méthode électrique permettant d'identifier des matériaux pouvant convenir à l'invention c'est-à-dire ayant une température de recristallisation élevée qui laisse, en fin de cycle de fabrication des cellules mémoire, le matériau utilisé dans l'état amorphe originel tel que déposé.
Les FIGURES 12a et 12b illustrent une méthode optique pour identifier des matériaux pouvant convenir à l'invention.

Les dessins joints sont donnés à titre d'exemples et ne sont pas limitatifs de l'invention.

### DESCRIPTION DÉTAILLÉE DE L'INVENTION

Les mémoires résistives dites PCM emploient un matériau dont on peut faire varier la structure atomique sous l'effet de la chaleur. Le matériau constituant l'élément mémoire peut évoluer entre deux phases solides principales : l'une ou le matériau adopte une structure organisée cristalline caractérisée par une faible résistance électrique ; et l'autre, où la structure atomique est inorganisée ou amorphe et présente une forte résistance électrique. Des états intermédiaires peuvent exister. Il convient ici de remarquer que seul l'état complètement cristallin est cependant naturellement stable. Dans un environnement où le matériau est soumis à des températures plus élevées que celle maximale pour laquelle il a été conçu d'opérer il tend naturellement à se réorganiser sous une forme cristalline. Les états amorphes sont énergétiquement qualifiés de métastables, l'information associée étant perdue si le matériau est soumis à un stress thermique.

Dans les mémoires électroniques de type PCM c'est le passage d'un courant de programmation qui provoque l'échauffement du matériau à changement de phase et son évolution entre ses différentes phases. En contrôlant durées et formes d'onde des pulses de programmation on obtient, après refroidissement, un état résistif que l'on pourra lire à l'aide de circuits périphériques adéquats. Traditionnellement, on qualifie d e « SET » le courant et l'opération de programmation qui permettent une recristallisation du matériau à changement de phase et, donc, l'obtention en lecture d'une faible valeur de résistance. Le courant de programmation, et l'opération dite de « RESET », provoquent ensuite une amorphisation, généralement partielle, du matériau à changement de phase jusqu'à obtenir un état résistif prédéterminé plus élevé qui sera caractéristique, en combinaison avec la faible résistance de l'état cristallin, de l'information stockée par l'élément mémoire.

Conventionnellement, l'opération de SET qui conduit à la recristallisation du matériau et à l'obtention d'une faible résistance délivre un courant élevé au circuit périphérique de lecture qui lit un « 1 ». L'opération de RESET qui provoque l'amorphisation du matériau conduit au résultat inverse : une forte résistance avec un courant faible délivré est lu comme étant un « 0 ». Fonctionnellement, la convention inverse sur les états logiques 0 et 1 peut aussi bien être adoptée sans inconvénient. Pour éviter toute confusion la présente demande ne fait aucune autre référence à ces états logiques 0 et 1 mais seulement aux deux états principaux, l'un amorphe à résistance élevée et l'autre cristallin à résistance faible.

Les états amorphe et cristallin sont qualifiés de stable dans le sens où ils demeurent dans leur état respectif en l'absence de forte contrainte thermique. Au-delà d'une certaine température, comme vu précédemment, leur état peut être altéré.

Comme on l'a vu sur le chapitre sur l'état de la technique les dispositifs actuels utilisent typiquement un chalcogénure connu sous l'acronyme de GST, un alliage de germanium (Ge), d'antimoine (Sb) et de tellure (Te), comme matériau à changement de phase capable de fonctionner à des températures jusqu'à 85°C pendant 10 ans. Le GST n'est donc pas susceptible de convenir pour réaliser des mémoires non volatiles qui peuvent être préprogrammées avant assemblage et qui doivent pouvoir supporter, sans perte d'information, le stress thermique jusqu'à 260°C du soudage par refusion.

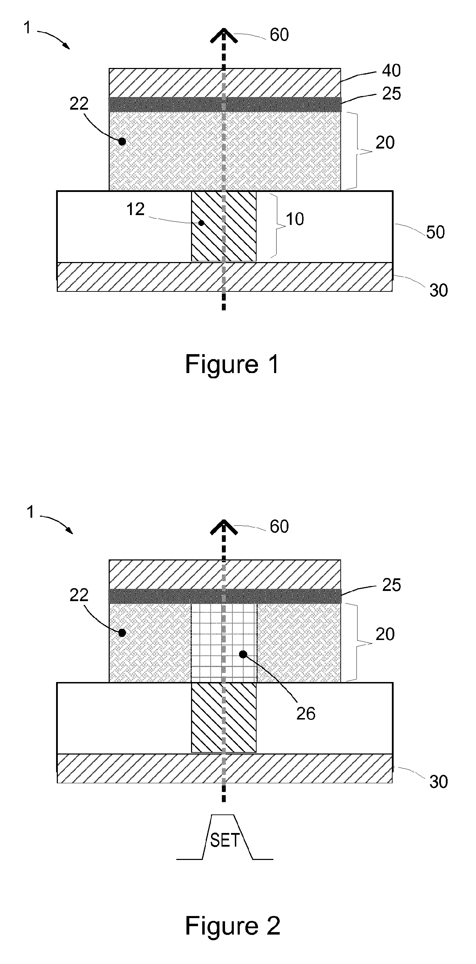

La **figure 1** illustre, à l'aide d'une vue coupe, une cellule mémoire 1 de type PCM qui permet de répondre à ce besoin. Cette structure comprend un moyen de chauffage 10 également désigné élément chauffant directement en contact à une de ses extrémités avec une couche 20 constituée d'un matériau à changement de phase 22. Le moyen de chauffage 10 ou élément chauffant 10 est généralement noyé dans une couche 50 d'un isolant, typiquement de l'oxyde de silicium (SiO2). Il est par exemple réalisé dans un métal 12 tel que le tungstène (W) qui peut supporter des températures élevées sans inconvénient.

La structure mémoire de l'invention est toutefois caractérisée, d'une part, en ce que le matériau à changement de phase 22 est différent du GST. Il s'agit préférentiellement d'un alliage de germanium (Ge), de tellure (Te) et de carbone (C) ce dernier élément étant présent à un pourcentage compris entre 1% et 25% et de préférence entre 3% et 25%. Cet alliage particulier à l'invention est dénommé GeTeCx% qui indique le pourcentage spécifique de carbone contenu dans les différents alliages effectivement utilisés pour mettre en oeuvre l'invention comme on va le voir ci-après.

La structure mémoire de la figure 1 est d'autre part caractérisée par la présence, sur la couche 20 du matériau à changement de phase 22 faite préférentiellement de GeTeCx%, d'une couche supplémentaire 25 de titane (Ti) d'une épaisseur typique comprise entre 3 et 10 nm, de préférence comprise entre 4.5 et 5.5 nm et encore plus préférentiellement d'environ 5 nm (1 nanomètre ou nm = 10⁻⁹ mètre). De préférence, cette couche de titane 25 est déposée directement au contact de la couche 20 de matériau à changement de phase 22.

On verra également que l'ajout de carbone dans un pourcentage compris entre 1% et 25% et de préférence entre 3% et 25% à l'alliage traditionnellement utilisé, le GST, en combinaison avec la couche de titane 25 dont l'épaisseur est comprise entre 3 et 8 nm, est une solution alternative particulièrement avantageuse. L'invention couvre également cette solution alternative.

Selon une alternative, le carbone (C) est remplacé par de l'indium (In). L'invention s'étend ainsi à un matériau à changement de phase formé d'un alliage comprenant du germanium (Ge) du tellure (Te) et de l'indium (In) ou formée d'un alliage comprenant du germanium (Ge), de l'antimoine (Sb), du tellure (Te) et de l'indium (In), le pourcentage d'indium (In) dans l'alliage étant compris entre 1% et 25% et de préférence entre 3% et 25%. Dans la suite de la description, ces deux alliages sont respectivement dénommés GeTelnx% et GSTInx%.

On désignera GeTeC/Inx% un alliage de germanium (Ge), de tellure (Te) additionné soit de carbone (C) soit d'indium (In). De même, on désignera GSTC/Inx% un alliage de germanium (Ge), d'antimoine (Sb) et de tellure (Te) additionné soit de carbone (C) soit d'indium (In).

Dans l'alliage de GeTeC ou GeTeln, le germanium et le tellure sont dans des proportions sensiblement stoechiométriques. Typiquement, ils sont dans des proportions relatives de 50/50 à plus ou moins 3%.

Dans l'alliage de GSTC ou GSTIn, le germanium, l'antimoine et le tellure sont dans des proportions sensiblement stoechiométriques. Typiquement, ils sont dans des proportions égales à plus ou moins 3% et de préférence à plus ou moins 1%. Selon un autre mode de réalisation, le germanium, l'antimoine et le tellure sont respectivement dans des proportions de 2, 2 et 5 soit 22%, 22% et 55%.

De manière inattendue, l'association de ces alliages présentant des proportions bien spécifiques de carbone ou d'indium avec une couche de titane 25 dont l'épaisseur présente également une épaisseur bien spécifique, fait agir cette couche de titane 25 comme un stabilisateur de la phase amorphe de l'alliage combattant ainsi la tendance naturelle à la recristallisation de ce type de matériau à changement de phase sous l'effet d'un stress thermique ou contrainte thermique.

La description qui suit fait plus particulièrement référence au mode de réalisation comprenant du GeTeCx% et une couche de titane, cependant, toutes les caractéristiques et avantages donnés pour ce mode de réalisation sont applicables aux modes de réalisation comprenant d'une part du GSTCx% ou du GeTelnx% ou du GSTInx% et d'autre part une couche de titane, l'invention n'étant pas limitative de l'un ou l'autre de ces modes de réalisation.

Comme on l'a vu précédemment, d'une façon conventionnelle avec ce genre de dispositif, pour programmer électriquement la structure mémoire de la figure 1, on va faire circuler un courant 60 entre des électrodes conductrices, qui auront été disposées de part et d'autre des couches incluant la couche 20 de matériau à changement de phase, le GeTeCx%, et sa couche de titane25. Le courant 60 circule donc entre une électrode inférieure 30 et une électrode supérieure 40 de la cellule à travers le moyen de chauffage 10 et les couches 20 et 25. C'est le passage du courant 60 qui provoque l'échauffement entraînant un changement stable de la structure atomique du matériau à changement de phase 22 après refroidissement.

L'invention prévoit spécifiquement que la couche de matériau à changement de phase, le GeTeCx%, est déposée de telle façon que le matériau est en fin de procédé de fabrication du dispositif dans un état amorphe. Ceci est obtenu classiquement à l'aide d'un dépôt effectué à basse température, voire à température ambiante, de type CVD ou PVD, acronymes de l'anglais « chemical vapor déposition » et « physical vapor déposition » c'est-à-dire, respectivement : « dépôt chimique en phase vapeur » et « dépôt physique en phase vapeur ».

Les phases ultimes du procédé de fabrication d'un dispositif du type de ceux produits par l'industrie de la microélectronique sont qualifiées de BEOL, acronyme de l'anglais « back-end of line » c'est-à-dire étapes de « fin de ligne » de fabrication. Elles consistent essentiellement à l'interconnexion des composants élémentaires, typiquement les cellules mémoire, entre eux, et vers l'extérieur, à l'aide de plages et de connexions métalliques définies par photolithographie. Par exemple, les étapes de BEOL sont réalisées après la définition du « Front End » i.e., les transistors pour la logique et les points mémoire. En pratique après la couche supérieure, en TiN par exemple comme dans un mode de réalisation décrit précédemment, on pourrait avoir : un dépôt d'oxyde d'encapsulation qui se fait à température élevée (350°C à 400°C pendant une ou plusieurs centaine de secondes) ; ensuite CMP ; ensuite le dépôt de la ligne de métal en cuivre par exemple, qui peut se faire à plus faible température (ie 250°C pendant une ou plusieurs centaine de secondes par exemple) ; ensuite un dépôt d'oxyde ou de SiN dit 'intermetal' (350°C à 400°C pendant une ou plusieurs centaine de secondes par exemple) ; puis on termine avec des plots en aluminium (eg 300°C).

De manière plus générale et habituelle, au cours de ces étapes de BEOL les cellules mémoires du type de celle décrite en figure 1 doivent supporter des températures allant jusqu'à 400°C, typiquement, pendant quelques minutes et jusqu'à une dizaine de minutes.

C'est une caractéristique de l'invention que le matériau à changement de phase choisi, le GeTeCx%, en combinaison avec sa couche en titane 25, ne va cependant pas recristalliser, sa température de cristallisation étant supérieure à cette valeur.

On peut aussi mettre en oeuvre des étapes de BEOL à des températures un peu moins élevées qui ne dépassent pas 350°C. Qualifié de BEOL « froid » ce type d'opérations de fin de ligne permet l'utilisation, de préférence en combinaison avec la couche de Titane, de matériaux comme le GST comprenant du carbone ou de l'indium mentionnés ci-dessus et dénommés respectivement GSTCx% et GSTInx%.

À ce stade on notera donc qu'une caractéristique de l'invention est qu'avant préprogrammation et assemblage, c'est-à-dire à l'issue des étapes de BEOL classique ou froid, toutes les cellules mémoires sont initialement dans l'état amorphe originel résultant du procédé de fabrication et de la structure décrits ci-dessus.

On notera que, dans le cadre de la présente invention, l'état amorphe originel est également désigné état originel fortement résistif ou état originel obtenu à l'issue de la fabrication des cellules mémoires et avant programmation des cellules mémoire, c'est-à-dire avant application d'un courant électrique de programmation. Par ailleurs, l'état cristallin est également désigné état faiblement résistif ou état obtenu par programmation électrique depuis l'état originel obtenu à l'issue de la fabrication des cellules mémoires et avant programmation des cellules mémoire.

L'état amorphe originel est un état dans lequel la structure du matériau à changement de phase peut être complètement amorphe. Cet état amorphe originel peut également être un état dans lequel la structure du matériau à changement de phase peut être partiellement cristallisée. Typiquement mais non limitativement le volume de matériau cristallisé est alors néanmoins inférieur à 30% du volume de matériau à changement de phase.

De manière générale, l'état amorphe originel est l'état, au moins en partie amorphe ou complètement amorphe, qui est obtenu à l'issue du procédé de fabrication des cellules mémoire et qui n'a été altéré par aucun passage de courant de programmation. Cet état amorphe originel est obtenu avant assemblage, par soudage ou par refusion par exemple, du dispositif contenant les cellules mémoire dans un système.

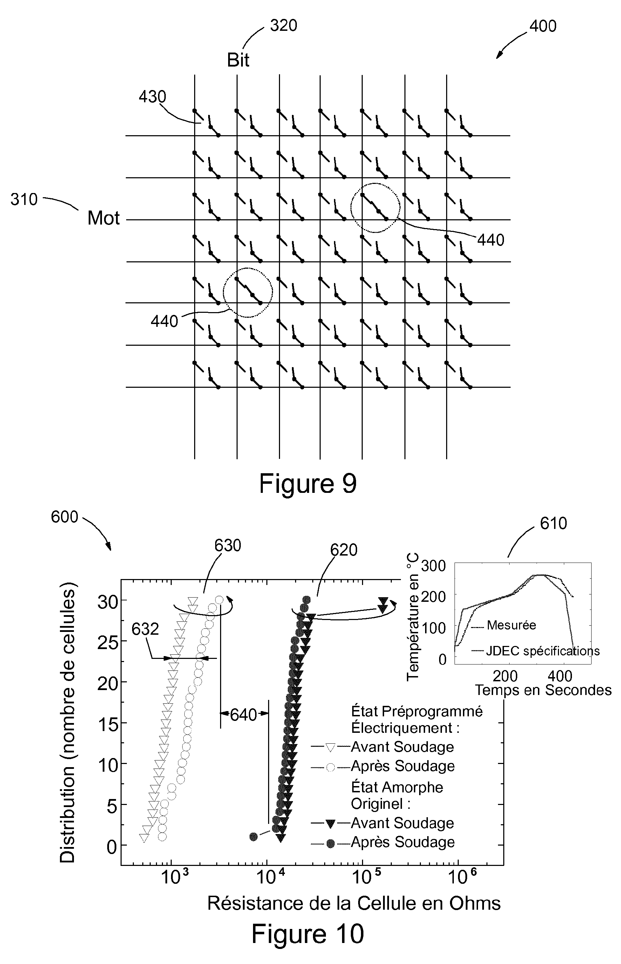

L'état amorphe originel se caractérise par une distribution de valeurs de résistances qui diffère d'au moins un facteur 1,5 et de préférence au moins un facteur deux par rapport à la distribution, après l'étape d'assemblage, de résistances des cellules mémoire se trouvant dans un état à plus faible résistance obtenue par programmation électrique. Cette différence de valeur de résistances entre les cellules dans l'état à forte résistance et les cellules dans l'état à faible résistance est clairement illustrée en figure 10 commentée ci-dessous.

Une autre caractéristique de l'invention qui est illustrée par la figure 2 est que la préprogrammation du dispositif PCM avant assemblage sur le circuit imprimé va consister à programmer électriquement certaines des cellules en y faisant passer un pulse de courant 60 adéquat de façon à ce qu'elles recristallisent localement 26 et présentent donc une résistance faible au circuit de lecture. Deux états électriques pourront ainsi être définis permettant de préstocker un bit d'information par cellule mémoire : celui à forte résistance correspondant à l'état amorphe originel issu du procédé de fabrication des cellules mémoire et qui n'a été altéré par aucun passage de courant de programmation ; et celui à faible résistance électriquement défini par une recristallisation locale 26 de certaines des cellules mémoires 1 obtenu par une opération de type SET décrite précédemment. Cette recristallisation 26 peut se présenter sous la forme d'une seule zone cristalline comme représentée de manière schématique sur la figure 2. Elle peut également être constituée d'une pluralité de filaments cristallins ou chemins de percolation cristallins. Avantageusement, ces chemins relient l'élément chauffant 10 à l'électrode 25.

Ces deux états ne vont donc pas être affectés par le stress thermique résultant de l'opération de soudage par refusion qui va suivre puisque, comme on l'a vu, la température maximum qui doit être supportée est alors de 260°C qui est bien inférieure aux 400°C des étapes classiques de BEOL ou aux 350°C des étapes de BEOL dit « froid ». En conséquence, les cellules qui auront été laissées dans l'état amorphe originel après préprogrammation resteront inchangées et celles qui auront été électriquement localement recristallisées ne seront pas non plus affectées puisque, comme on l'a déjà vu également, l'état cristallin est naturellement stable. Une légère dérive peut néanmoins être observée comme expliqué en référence à la figure 10.

L'objectif de l'invention est ainsi atteint qui permet de continuer à préprogrammer avant assemblage et soudage par refusion les dispositifs mémoire de type PCM fabriqués selon le procédé et la structure de l'invention.

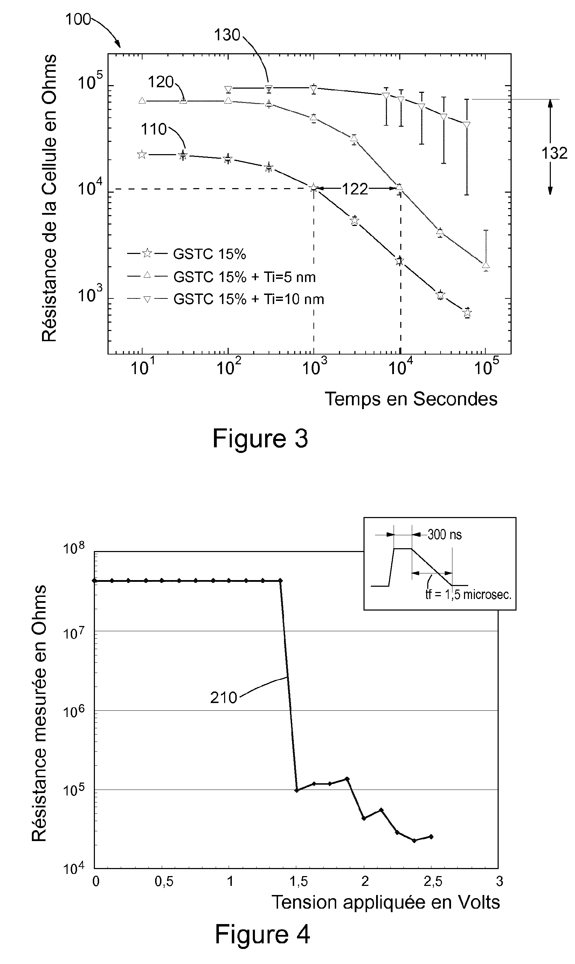

La figure 3 montre des résultats expérimentaux venant étayer les résultats obtenus avec le mode de réalisation de l'invention décrit dans les figures précédentes. Le diagramme 100 indique, en ordonnée, les résistances mesurées en fin de procédé, après les étapes de BEOL, de cellules mémoires PCM réalisées selon trois options différentes. Dans les trois cas le matériau est du GST dopé au carbone dans une proportion de 15% (GSTC15%). Le diagramme montre l'influence de la présence de la couche 25 de titane et de son épaisseur. La courbe 110 concerne, pour comparaison, des dispositifs sans couche de titane. La courbe 120 représente le comportement de dispositifs réalisés avec une couche de titane d'une épaisseur de 5 nm où l'on constate bien une amélioration 122 du temps de rétention d'un ordre de grandeur (x10). L'augmentation de l'épaisseur de la couche de titane accentue encore cette amélioration comme montré sur la courbe 130 correspondant à une épaisseur de titane de 10 nm avec toutefois une dispersion 132 plus grande des résultats obtenus.

On notera ici que dans le cadre de la présente invention les pourcentages de carbone ou d'indium mentionnés sont ceux réellement mesurés dans l'alliage correspondant par exemple à l'aide des méthodes suivantes bien connues telles que :
- EELS acronyme de electron energy loss spectroscopy qui signifie spectroscopie par perte d'énergie d'électron ou
- EDX acronyme de energy dispersive x-ray spectroscopy qui signifie l'analyse dispersive en énergie.
Ces deux méthodes sont bien adaptées pour analyser la composition de dispositifs de petites tailles telles que des cellules mémoire. Elles peuvent être appliquées sur des coupes obtenues par TEM acronyme de Transmission Electron Microscopy c'est-à-dire par microscopie électronique en transmission.

Les méthodes suivantes peuvent également être utilisées, mais elles s'appliquent à des dimensions plus grandes, typiquement à des plaques : celles dite RBS, acronyme de l'anglais « Rutherford backscattering spectrometry » c'est-à-dire : « spectroscopie de rétrodiffusion de Rutherford » utilisée pour déterminer la structure et la composition de matériaux par l'analyse de la rétrodiffusion d'un faisceau d'ion à haute énergie frappant un échantillon. D'autres méthodes sont aussi utilisées dans le même but comme celles dites PIXE, acronyme de l'anglais « particle-induced X-ray emission » c'est-à-dire « émission de photons X induite par particules »

Les pourcentages exprimés sont des pourcentages molaires c'est-à-dire représente le rapport du nombre d'atomes de l'espèce concernée, le carbone par exemple, sur le nombre total d'atomes de l'alliage. C'est donc un nombre sans dimension mesuré dans le matériau à changement de phase après fabrication de la cellule mémoire.

La **figure 4** illustre l'opération de SET ou recuit électrique qui est appliqué sur certaines des cellules mémoires en vue de leur préprogrammation avant assemblage dans un circuit imprimé et donc avant soudage par refusion. Cette opération de SET s'effectue à partir du matériau amorphe originel obtenu en fin de procédé de fabrication d'une tranche, c'est-à-dire après les étapes de BEOL, et correspond au cas d'un matériau et d'une structure référencés 120 dans la figure 3 et à la structure de la figure 1 où le matériau à changement de phase est du GeTeCx%, entre 7 et 16%, en combinaison avec une couche de titane d'une épaisseur de 5nm.

L'opération de SET ou recuit électrique après BEOL consiste à appliquer une tension suffisante entre les électrodes 30 et 40 de chaque cellule qui doit être préprogrammée de façon à la recristalliser localement 26 comme schématisé sur la figure 2. Cela est obtenu en appliquant un pulse de tension, typiquement d'une durée de 300 nanosecondes (nanoseconde ou nm = 10⁻⁹ seconde) et d'une amplitude suffisante pour provoquer localement une brusque transition depuis l'état amorphe initial également désigné état amorphe originel. Combiné avec des temps de descente (t_{f}) plus lents, de l'ordre de 1,5 microseconde (10⁻⁶ seconde), cela permet d'obtenir un refroidissement progressif qui assure une bonne recristallisation du matériau à changement de phase et donc une faible résistance électrique. La courbe 210 de la figure 4 montre la résistance mesurée après application de l'impulsion électrique. Il faut donc appliquer, dans cet exemple correspondant à du GeTeC7%, un pulse d'une amplitude d'au moins 1,5 volt pour obtenir la transition cristalline depuis l'état amorphe originel obtenu après fabrication des tranches selon le procédé et avec la structure de l'invention.

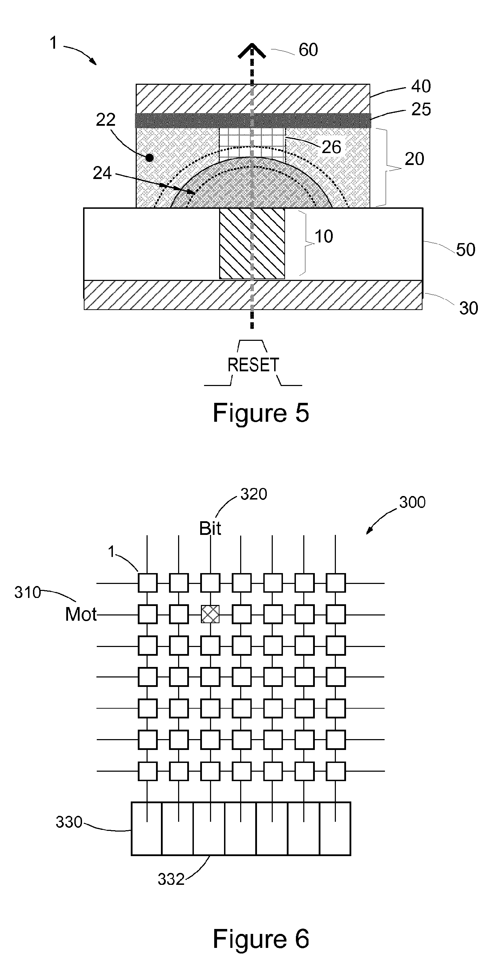

La **figure 5** illustre l'opération de RESET électrique qui est effectuée lors de l'utilisation fonctionnelle du dispositif après qu'il a été assemblé, par exemple, dans un système embarqué informatisé. Le RESET, c'est-à-dire l'amorphisation électrique du matériau à changement de phase pour programmer une cellule est une opération standard qui va potentiellement pouvoir être effectuée tout au long de la vie du dispositif chaque fois que l'on voudra remettre une cellule mémoire dans un état à haute résistance. Comme expliqué précédemment, l'opération de RESET électrique consiste à faire passer dans le dispositif un courant 60 dont on contrôle durée et forme d'onde pour qu'après refroidissement le matériau soit dans un état amorphe.

Ici, il est important de remarquer que l'état amorphe obtenu électriquement est différent de l'état amorphe originel résultant du procédé de fabrication du dispositif et qui n'a pas été affecté par les étapes de BEOL. En particulier, la zone rendue électriquement amorphe se développe typiquement sous la forme d'une corolle de champignon 24 plus ou moins étendue à partir du moyen de chauffage 10. La zone 24 rendue électriquement amorphe empêche le passage du courant dès qu'elle est suffisamment étendue ce qui a pour effet de remettre dans l'état haute résistance la cellule mémoire. En utilisation normale du dispositif, après préprogrammation et soudage du dispositif contenant les mémoires PCM sur un circuit imprimé, il peut subsister des zones cristallines 26 d'une précédente cristallisation

Il est aussi important de remarquer que cette amorphisation électrique ne peut en aucun cas, quelles que soient les caractéristiques du pulse de programmation utilisé : durée, forme et intensité, permettre de retrouver l'état amorphe originel qui seul peut supporter sans inconvénient le stress thermique du soudage par refusion lors de l'assemblage. En effet, c'est l'état fortement désordonné de la phase amorphe originelle qui crée une barrière énergétique suffisamment élevée pour empêcher sa recristallisation lors du soudage (ou lors de toute autre opération générant un stress thermique) et confère à l'alliage choisi, en combinaison avec la couche de titane, sa stabilité thermique. L'amorphisation électrique ne lui confère pas cette propriété.

On remarquera finalement que la couche 20 du matériau à changement de phase 22 est dans l'état amorphe originel sur toute son épaisseur qui est typiquement de 100 nm. La corolle 24, formée électriquement, peut être beaucoup plus mince puisqu'il suffit qu'elle obstrue le chemin de conduction depuis le moyen de chauffage 10 pour rendre la cellule mémoire hautement résistante.

La **figure 6** illustre une structure conventionnelle de mémoire comprenant une cellule mémoire PCM. D'une façon générale les mémoires, ou matrice de cellules mémoire, fabriquées par l'industrie de la microélectronique sont organisées sous forme d'une matrice 300 de lignes et de colonnes dans laquelle une cellule mémoire 1 est placée à chaque intersection. La sélection d'une cellule mémoire se fait à l'aide de moyens non représentés en activant une ligne et au moins une colonne simultanément. Traditionnellement, chaque ligne sert à sélectionner un mot et est appelé « ligne de mot » 310. Chaque colonne sert à sélectionner un bit du mot et est donc appelée « ligne de bit » 320. Au bout des lignes de bit on place des circuits de lecture et d'écriture 330 qui servent à lire le contenu des cellules et à le modifier. Classiquement, pour des questions de performance et de simplicité de mise en oeuvre, chaque ligne de bit est pourvue de son propre circuit de lecture et d'écriture 332.

Dans le cas des mémoires PCM chaque circuit de lecture est conçu d'une part, en lecture, pour pouvoir discriminer au moins deux niveaux de résistance correspondant aux états principaux : amorphe et cristallin. D'autre part, en écriture, chaque circuit 332 est au minimum capable de générer un pulse ou une série de pulses contrôlés de SET et de RESET afin de modifier la phase cristalline ou amorphe d'une cellule mémoire dont on désire changer le contenu. On notera qu'en cas d'écriture la procédure peut consister à d'abord systématiquement remettre le matériau dans sont état amorphe à haute résistance (RESET) avant de procéder optionnellement à une recristallisation (SET) s'il faut y mémoriser un état à faible résistance.

Selon un aspect particulier de l'invention, chaque circuit de lecture et d'écriture 332 va aussi inclure les moyens pour pouvoir faire la différence entre plus de deux états du matériau à changement de phase. C'est-à-dire que seul, ou en combinaison avec d'autres circuits de contrôle (non représentés) du dispositif mémoire, les circuits de lecture et d'écriture 330 vont être capables de reconnaître tous les états qui ont été mentionnés précédemment et rappelés ci-après :

| États : | Mode: |
|---|---|
| État amorphe originel à haute résistance obtenu à l'issue du procédé de fabrication d'une tranche et qui reste inchangé après les étapes de BEOL. La couche de matériau PCM 22 est initialement dans cet état. | Lecture avant (par exemple pour vérification) ou après assemblage |
| État cristallin obtenu électriquement par le passage d'au moins un pulse de SET adapté en durée, forme et intensité pour provoquer une recristallisation locale 26 depuis l'état amorphe originel initial afin de préprogrammer une sélection de cellules avant soudage par refusion d'un dispositif PCM selon l'invention dans un système embarqué (recuit électrique). | Écriture lors de la préprogrammation, possiblement avant une étape d'assemblage générant un stress thermique. |
| | Lecture avant (par exemple pour vérification) ou après assemblage |
| État amorphe à haute résistance obtenu électriquement par le passage d'au moins un pulse de RESET adapté en durée, forme et intensité pour provoquer une amorphisation locale 24 en mode fonctionnel. | Écriture et lecture en mode fonctionnel |
| État cristallin à faible résistance obtenu électriquement par le passage d'au moins un pulse de SET adapté en durée, forme et intensité pour provoquer une recristallisation locale 26 en mode fonctionnel. | Écriture et lecture en mode fonctionnel |

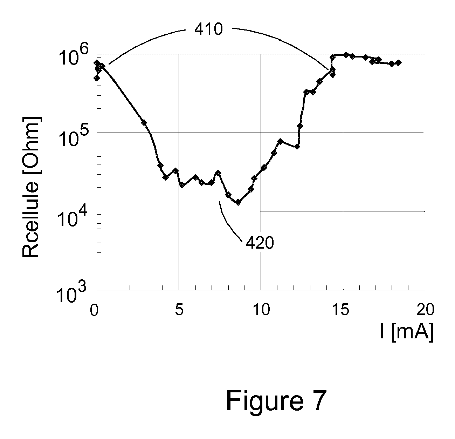

La **figure 7** montre un exemple de valeurs de résistance résultant des opérations de SET et RESET électriques décrites ci-dessus. Cette figure illustre le mode fonctionnel normal d'une cellule mémoire selon l'invention où l'on peut faire évoluer réversiblement la résistance de la cellule entre des valeurs élevées 410 correspondant à un état amorphe électrique et des résistances faibles 420 correspondant à un état cristallin.

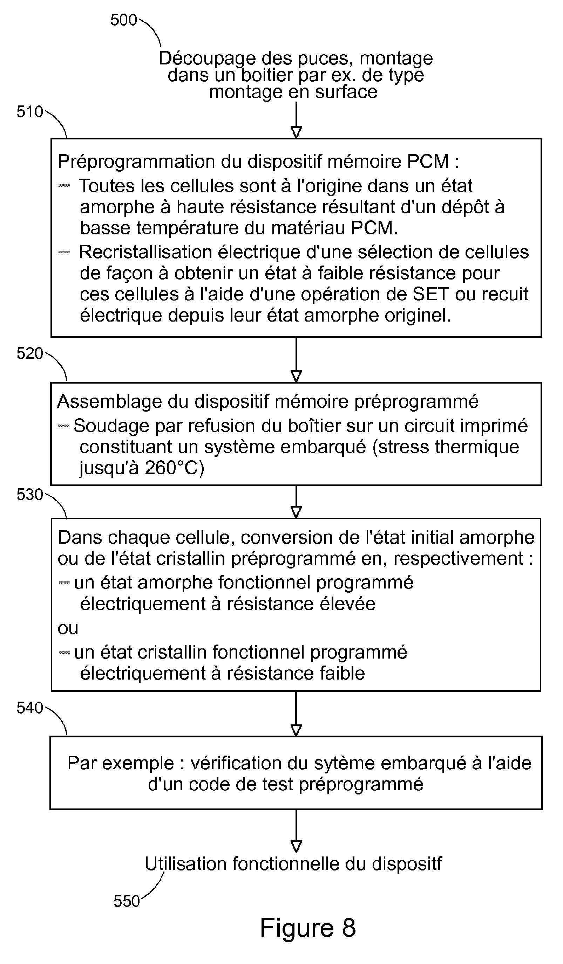

La **figure 8** décrit un exemple de procédure de mise en oeuvre de l'invention depuis la phase de préprogrammation jusqu'à l'étape d'utilisation fonctionnelle d'un dispositif mémoire PCM dans un ensemble de type système embarqué informatisé.

Dans l'exemple illustré par la figure 8 la procédure s'applique typiquement en fin de fabrication de la tranche sur laquelle une puce, c'est dire un ensemble de cellules mémoire, aura été fabriqué. Le plus souvent de très nombreuses cellules mémoire sont fabriquées sur une même tranche et seule une partie d'entre elles sont incorporées dans un même dispositif.

La première étape illustrée en figure 8 est l'étape 500 qui représente le montage de la puce dans un boîtier par exemple du type boîtier à montage en surface d'un circuit imprimé. A ce stade, le dispositif mémoire comprend alors le boîtier ainsi que des cellules mémoire. Si les cellules mémoires de plusieurs dispositifs sont fabriquées sur une même tranche, l'étape de montage est précédée d'une étape de découpe de la tranche.

Comme on le verra en détail par la suite, la préprogrammation peut aussi se pratiquer au niveau tranche, avant découpage des puces, par exemple à l'aide d'un appareillage adéquat qui donne accès successivement aux plages ou plots de connexion de chacune des puces sur la tranche. Appareillage comme ceux utilisés pour tester les circuits intégrés sur tranche du type « machine de test sous pointes ».

L'étape 510 consiste à préprogrammer avec un code ou des données spécifiques les dispositifs que l'on destine à une application particulière. Toutes les cellules sont initialement dans un état amorphe originel à haute résistance tel que déposé. La préprogrammation consiste à recristalliser électriquement une sélection de cellules afin de leur conférer une faible résistance électrique à l'aide d'une opération de SET à partir de l'état amorphe originel. La recristallisation est partielle 26.

On notera que selon un mode de réalisation la préprogrammation 510 au niveau de chaque tranche est effectuée après montage, typiquement dans un boîtier, des cellules mémoires. L'étape de préprogrammation est donc effectuée après une éventuelle découpe de la partie de tranche comprenant les cellules du dispositif à incorporer dans le boîtier. Dans ce mode de réalisation, l'étape 500 est donc effectuée avant l'étape 510 illustrée en figure 8.

Selon un autre mode de réalisation la préprogrammation 510 au niveau de chaque tranche est effectuée avant montage 500 des cellules mémoires typiquement dans un boîtier. Cette étape de préprogrammation peut même être effectuée avant la découpe de la partie de tranche comprenant les cellules à incorporer dans le boîtier. Dans ce mode de réalisation, l'étape 510 est donc effectuée avant l'étape 500.

Comme on l'a vu, les états ci-dessus sont thermiquement stables. On peut alors procéder à l'assemblage 520 du ou des dispositifs mémoire PCM et des autres dispositifs constituant le système embarqué. Au cours de cette opération on peut par exemple souder par refusion tout ou partie des composants sur le circuit imprimé. Ceci a pour effet d'appliquer un stress thermique jusqu'à 260°C aux composants du système embarqué sans cependant qu'il y ait perte de l'information préprogrammée dans les cellules mémoires PCM de l'invention pour les raisons mentionnées précédemment et rappelées ci-après. En effet, d'une part, la température de recristallisation du matériau utilisé, initialement amorphe, et la structure de la cellule, font que cette température est au moins supérieure aux 350°C d'un BEOL dit froid et donc bien supérieure aux 260°C du stress thermique dû au soudage. D'autre part, les cellules ayant subies une recristallisation partielle sont naturellement stables.

De manière optionnelle mais avantageuse, après assemblage on procède à la conversion 530 des états préprogrammés. En effet, l'état amorphe originel ne peut pas être reproduit électriquement et pourra ne pas être utilisable fonctionnellement. Par ailleurs, l'opération de recristallisation électrique à partir de l'état amorphe originel peut être significativement différente d'une opération de SET fonctionnelle. Notamment, parce que les opérations de RESET et de SET fonctionnelles sont adaptées pour être les plus performantes possibles en terme de vitesse d'exécution alors que la préprogrammation, exécutée une seule fois, n'a pas à être particulièrement rapide et doit s'attacher seulement à produire un état stable capable de résister au stress thermique du soudage.

Comme discuté précédemment, la conversion va se faire en utilisant les caractéristiques particulières à l'invention des circuits de lecture et d'écriture 330 apparaissant dans la figure 6 ; ceci, possiblement, sous le contrôle d'une circuiterie spécialisée (non représentée) destinée à effectuer automatiquement cette conversion après assemblage.

Selon une première option, lors de l'étape 530 de conversion on peut convertir chaque cellule présentant un état amorphe originel et chaque cellule présentant un état cristallin préprogrammé en, respectivement : une cellule présentant un état amorphe fonctionnel programmé électriquement à résistance élevé, et une cellule présentant un état cristallin fonctionnel programmé électriquement à résistance faible.

Selon une deuxième option, non illustrée en figure 8, lors de l'étape de conversion, on peut convertir chaque cellule présentant un état amorphe originel et chaque cellule présentant un état cristallin préprogrammé en, respectivement : une cellule présentant un état cristallin fonctionnel programmé électriquement à résistance faible et une cellule présentant un état amorphe fonctionnel programmé électriquement à résistance élevé. Ainsi, dans ce mode de réalisation on inverse les phases cristalline et amorphe lors de l'étape de conversion.

Optionnellement, en fonction de mises en oeuvre particulières de l'invention il ne sera pas nécessaire de convertir les états préprogrammés en des états fonctionnels amorphe et cristallin. Par exemple, les circuits de lecture 330 pourront être conçus pour être compatibles et capable de différencier entre, d'une part, un état amorphe originel ou un état amorphe électrique et, d'autre part, un état cristallin préprogrammé ou un état cristallin fonctionnel. L'information stockée étant le plus généralement binaire il suffit en effet de distinguer entre deux états à haute résistance (amorphe originel ou amorphe électrique) et deux états à faible résistance (cristallin préprogrammé depuis l'état amorphe originel ou cristallin fonctionnel) pour pouvoir lire deux états différents. Dans ce mode de réalisation, l'étape correspondant à l'étape référencée 530 en figure 8 est donc supprimée.

Dès que la conversion aura été exécutée, si elle est nécessaire, le code ou les données préprogrammés pourront être utilisés fonctionnellement. Typiquement, au moins un code de test 540 du système embarqué aura été préprogrammé. Il va pouvoir être exécuté sous le contrôle d'un microprocesseur ou microcontrôleur afin de s'assurer de l'intégrité du système embarqué et de son bon fonctionnement.

Le code et/ou les données nécessaires au fonctionnement du système embarqué pourront également avoir été préprogrammés et convertis comme expliqué ci-dessus si nécessaire. Auquel cas le système embarqué peut devenir immédiatement fonctionnel 550.

Optionnellement, seul le code de test peut avoir été programmé. Dans ce cas, il faudra procéder au chargement in situ du code opérationnel avant utilisation du système embarqué avec les inconvénients mentionnés dans le chapitre sur l'état de la technique.

Quelles que soient les options choisies qui dépendent essentiellement de l'application et de paramètres tels que la taille mémoire disponible, la possibilité de pouvoir préprogrammer avant assemblage un dispositif mémoire PCM selon l'invention préserve tous les avantages qu'offre cette technique dans le cadre d'une production industrielle de systèmes embarqués. Avantages qui sont perdus si on utilise une mémoire standard non volatile de type PCM.

La **figure 9** illustre plus particulièrement une application avantageuse de l'invention quand, par exemple dans un système embarqué, on fait appel à l'utilisation d'un composant mémoire à lecture seule, ou mémoire morte, le plus souvent cependant désigné par son acronyme ROM de l'anglais « read-only memory ». Typiquement, on a recours à ce type de composants pour mémoriser le code opérationnel d'un système embarqué à l'issue de sa période de développement quand il n'est plus susceptible de devoir être changé. La programmation d'une telle mémoire se fait une seule fois pour une application donnée. Ce type de composants est ainsi qualifié d'OTP, acronyme de l'anglais « one-time programmable » ce qui signifie programmable une seule fois. La programmation peut se faire en générant des masques de fabrication spécifiques à chaque application. Ceci est évidemment assez coûteux et ne se justifie généralement que pour des dispositifs produits en très grandes quantités. Il existe d'autres types de mémoires OTP à lecture seule. Il s'agit notamment de celles qui utilisent pour chaque point mémoire des « fusibles » ou « anti-fusibles » électriquement programmable une fois. Un fusible étant comme le nom le suggère un élément conducteur « fermé » que l'on va pouvoir faire fondre pour programmer un état « ouvert » non conducteur. Un anti-fusible étant l'opposé, il est normalement ouvert et la programmation permet de le fermer, c'est-à-dire de l'amener dans un état conducteur à faible résistance. C'est ce type de matrice mémoire qui est schématisé sur la figure 9. D'une façon conventionnelle, comme déjà décrit dans la figure 6, la mémoire est organisée sous la forme d'une matrice de lignes 310 et de colonnes de points mémoires qui sont normalement ouverts 410 à l'issue des étapes de fabrication. La programmation va consister à fermer 420 certains des anti-fusibles au cours d'une phase préliminaire de personnalisation de la matrice pour une application particulière du système embarqué dans laquelle elle est utilisée. Ainsi la matrice comprend à chaque croisement entre ligne et mot un point mémoire, et de préférence également son élément sélecteur, ceci pour éviter les courants de fuite pendant l'opération de lecture, en configuration sans élément sélecteur.

L'invention est particulièrement adaptée à ce type d'application puisque les alliages PCM préconisés, caractérisés par une température de cristallisation élevée, ne sont affectés, comme on l'a vu, ni par les traitements thermiques de fin de procédé (BEOL) ni par ceux résultant du soudage par refusion des puces dans leurs boîtiers. En fin de procédé les cellules mémoires décrites précédemment qui constituent la matrice 400 sont alors toutes dans un état à résistance élevée résultant du dépôt dans une phase amorphe de l'un ou l'autre des matériaux préconisés par l'invention. Toutes les cellules de la mémoire ROM sont donc initialement dans un état « ouvert » 410 comme dans le cas d'un anti-fusible. La programmation va pouvoir se faire sur la tranche elle-même en appliquant à partir de moyens électriques de sélection des rangées 310 et de moyens d'écriture situés en pied de colonne 320 chacune des cellules qui doivent être programmées dans un état « fermé » 420, c'est-à-dire dans un état à faible résistance. Les moyens électriques de sélection et d'écriture sont similaires à ceux décrits en figure 6. Optionnellement la programmation pourra aussi se faire in situ.

Toutes les cellules non programmées restent dans leur état amorphe originel obtenu en sortie de procédé. C'est, comme on l'a vu, un état à forte résistance qui est naturellement stable et qui n'évoluera pas pendant toute la durée de vie du dispositif qui emploie ces mémoires. Dispositif qui peut être prévu pour fonctionner dans un environnement à température élevée en raison de la température de cristallisation elle-même élevée des matériaux à changement de phase préconisés par l'invention. Un tel dispositif est ainsi parfaitement adapté pour fonctionner à proximité d'organes dégageant d'importantes quantités de chaleur tels que des moteurs à combustion que l'on rencontre par exemple dans le domaine automobile.

La programmation des cellules dans leur état fermé 420, à faible résistance, se fait une seule fois depuis l'état amorphe originel, comme expliqué en figure 4, à l'aide d'une opération de SET ou recuit électrique. L'état cristallin à faible résistance obtenu est aussi naturellement stable et n'évoluera pas non plus pendant toute la durée de vie du dispositif. On obtient ainsi une mémoire programmable à lecture seule (PROM). On notera ici que les moyens d'écriture mentionnés ci-dessus n'ont à être conçus que pour permettre une seule exécution d'une opération de SET depuis l'état amorphe originel. Le circuit correspondant pourra être simplifié. L'écriture n'étant faite qu'une fois, la vitesse d'exécution de cette opération n'est pas critique et n'a pas d'impact sur le mode fonctionnel qui est en lecture seule.

Optionnellement, le circuit d'écriture pourra être conçu pour permettre qu'une opération de RESET puisse aussi se faire dans le but de corriger une programmation incorrecte d'un état à faible résistance. Cependant, comme déjà discuté, on ne peut pas alors retrouver l'état amorphe originel à forte résistance. Ce mode de personnalisation peut toutefois s'envisager, au prix d'une complication des moyens d'écriture par rapport au cas précédent, pour permettre que la mémoire devienne électriquement reprogrammable, en particulier si la correction n'affecte qu'une petite partie des points mémoires la majorité restant alors dans leur état amorphe originel.

Il y a plusieurs avantages liés à l'utilisation d'une telle mémoire PROM :
- Dans le cas, très fréquent, d'utilisation simultanée de ROM et de mémoire non volatile dans un même dispositif la même technologie et le même procédé peuvent alors être utilisés pour les deux types de mémoire.
- L'information peut être programmée au niveau tranche, en fin de ligne de fabrication et avant montage des puces, avec les avantages mentionnés dans le chapitre sur l'état de la technique concernant les données confidentielles que ces mémoires peuvent avoir à contenir. Ces données peuvent en effet être introduites avant assemblage afin de ne pas avoir à contrôler la distribution de ces informations sensibles au-delà de la chaîne de fabrication.
- Contrairement aux mémoires à fusible il est très difficile, sinon impossible, de pratiquer sur ces circuits ce qui est généralement qualifié de « reverse engineering » ou « ingénierie inversée ». Au cours d'une opération de reverse engineering on vise à retrouver la programmation d'une PROM en observant avec un microscope, par exemple de type microscopie électronique en transmission (TEM), les fusibles programmés, c'est-à-dire ceux qui ont été fondus lors de la programmation. Avec les mémoire de type PROM, cette opération de visualisation de l'état résistif des points mémoire est aisée et couramment pratiquée pour analyser les produits de concurrents ou récupérer des données. Avantageusement, en utilisant une cellule mémoire selon l'invention, la modification physique du matériau des points mémoires fermés, ceux où une faible résistance a été programmée, n'est au contraire pas visualisable. L'invention offre ainsi un avantage considérable en terme de sécurisation des données.

Dans le cadre du développement de la présente invention, il a en effet été constaté que la cellule mémoire dans l'état amorphe originel se distingue de la cellule mémoire dans l'état cristallin obtenu depuis l'état amorphe originel uniquement en ce que, dans l'état amorphe originel, une portion de la couche de matériau à changement de phase est dans un état amorphe alors que, dans l'état cristallin obtenu depuis l'état amorphe originel, cette même portion de la couche de matériau à changement de phase est percée. Cette différence, portant donc uniquement sur la rupture partielle d'une portion de la couche de matériau à changement de phase n'est pas ou est très difficilement détectable par une observation avec un TEM. La portion de la couche 20 du matériau à changement de phase 22 utilisé dans le cadre de la présente invention dont la phase varie est située à proximité du moyen de chauffage 10. A l'inverse, il a été remarqué qu'une autre portion du matériau à changement de phase 22, portion éloignée du moyen de chauffage 10, ne voit pas sa phase varier lorsque la cellule passe d'un état fortement résistif à un état faiblement résistif. Cette portion de matériau à changement de phase 22 éloignée du moyen de chauffage demeure en effet dans l'état amorphe originel.

Ainsi, dans une matrice de cellules mémoire utilisant la présente invention, toutes les cellules mémoire présentent au moins une portion qui est éloignée du moyen de chauffage et qui est dans un état amorphe et ceci que la cellule soit dans un état fortement résistif, i.e., toute la couche est dans un état amorphe, ou que la cellule soit dans un état faiblement résistif, i.e., seule une ou des portions de la couche qui est/sont éloignées du moyen de chauffage se trouve/ent dans un état amorphe, la portion à proximité du moyen de chauffage étant dans un état cristallin.

Une observation d'une portion du matériau à changement de phase loin du moyen de chauffage, par exemple avec un TEM, permet de savoir si cette portion est dans un état cristallin ou amorphe. Comme indiqué précédemment en référence à la figure 2, la portion cristallisée peut comprendre une pluralité de filaments cristallins que l'on peut également désigner chemins de percolation cristallins. C'est au voisinage du moyen de chauffage, comme indiqué précédemment, qu'il est très difficile voire impossible de déterminer si le matériau de l'invention est dans un état amorphe ou cristallin.

La **figure 10** illustre l'effet bénéfique de l'utilisation d'une cellule mémoire selon l'invention, dans laquelle le matériau à changement de phase est un alliage de germanium, de tellure, d'antimoine et de carbone dans une proportion réelle de 15% (GSTC15%), cette proportion étant une proportion réelle et la proportion nominale étant de 5%. Dans cette cellule mémoire, la couche de titane présente une épaisseur d'environ 5 nanomètres. Le diagramme 600 montre la distribution des états résistifs de telles cellules mesurés avant et après une opération de soudage par refusion dont le profil est indiqué dans l'insert 610.

On constate que la distribution 620 des états résistifs des cellules qui ont été laissées dans l'état amorphe originel tel que déposé est pratiquement inchangée.

On constate par ailleurs que la distribution 630 des cellules qui ont été préprogrammées depuis leur état amorphe originel à une valeur de résistance plus faible, à l'aide d'un recuit électrique comme discuté précédemment, subit une légère dérive 632 qui préserve cependant une marge suffisante 640 entre les deux états (fortement résistif et faiblement résistif) pour les différencier à la lecture et retrouver, après assemblage (typiquement soudage), les informations préprogrammées. Cette dérive est principalement due à l'étape d'assemblage. De préférence cette marge correspond à une différence de résistance au moins égale à un facteur 1,5 et de préférence au moins égale à un facteur 2. Ainsi, on choisi le matériau à changement de phase de manière à ce que la distribution 620 des résistances des cellules dans l'état amorphe originel est au moins 1,5 fois et de préférence au moins deux fois supérieure à la distribution 630, après l'étape d'assemblage (donc après dérive), des résistances des cellules qui ont été préprogrammées depuis leur état amorphe originel.

Comme indiqué précédemment, le procédé de préprogrammation de la présente invention s'applique à de nombreux types de matériaux à changement de phase et n'est pas limité aux seuls exemples avantageux mentionnés ci-dessus. Les paragraphes qui suivent décrivent deux méthodes pour identifier des matériaux qui peuvent être employés dans le cadre de la présente invention.

De manière générale, les matériaux qui peuvent être employés dans le cadre de la présente invention sont les matériaux pour lesquels la distribution 620 des résistances des cellules dans l'état amorphe originel est au moins 1,5 fois et de préférence au moins deux fois supérieure à la distribution 630 des résistances des cellules qui ont été préprogrammées depuis leur état amorphe originel.

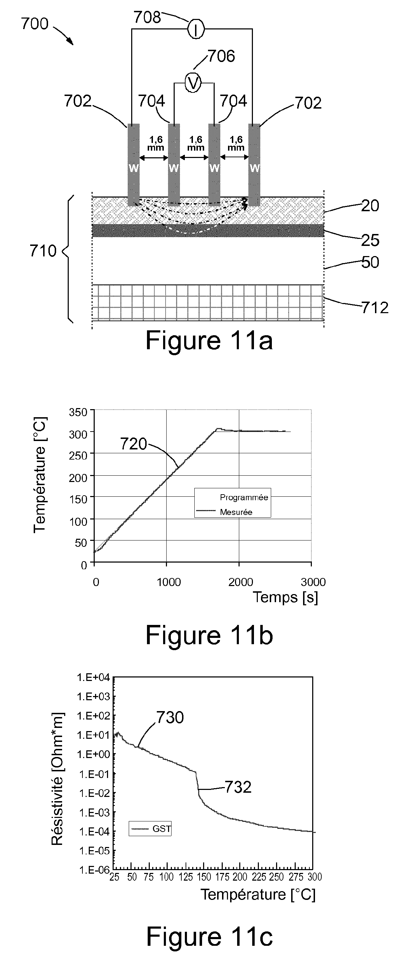

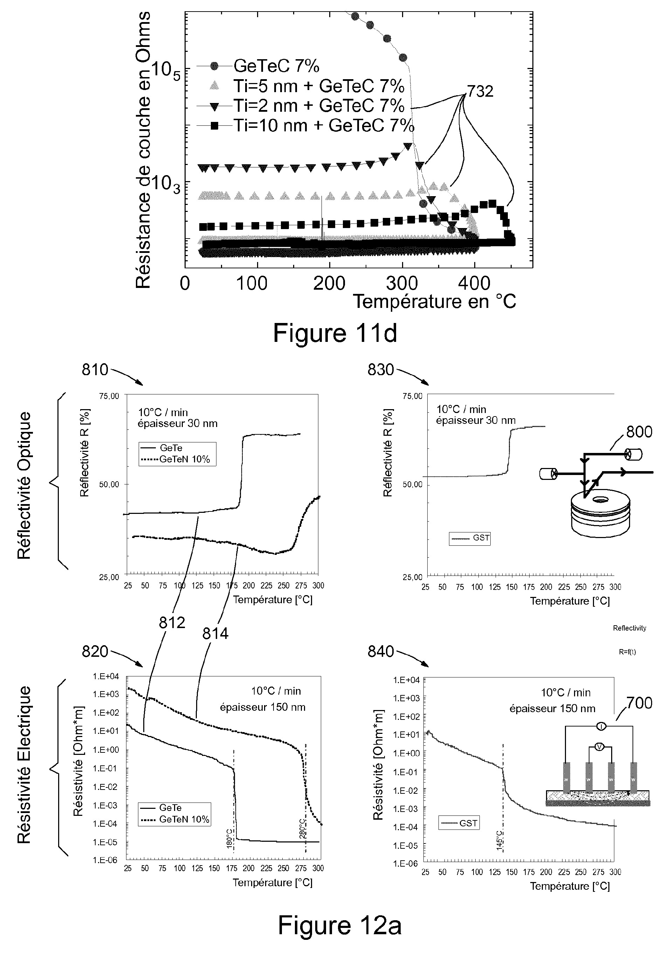

Les **figures 11**a **à 11 d** illustrent une première méthode permettant d'identifier des matériaux pouvant convenir à l'invention c'est-à-dire ayant une température de recristallisation élevée qui laisse le matériau utilisé dans l'état amorphe originel tel que déposé en fin de cycle de fabrication, après BEOL.

La figure 11a schématise l'équipement de mesure 700 qui est l'outil traditionnel utilisé en microélectronique pour évaluer la résistance électrique des couches déposées. La mesure est effectuée sur des tranches 710 où l'on a déposé en surface une couche continue du matériau à mesurer. L'outil est constitué de quatre sondes ou pointes de test, 702 et 704, généralement en tungstène (W), que l'on vient appliquer sur la couche à mesurer c'est-à-dire, dans le cadre de l'invention, sur la couche de matériau à changement de phase 20 que l'on désire évaluer. La mesure de la résistivité est effectuée en injectant un courant 708 entre les pointes extérieures 702 et en mesurant la différence de potentiel 706 entre les pointes intérieures 704. Cette méthode est largement pratiquée par toute l'industrie de la microélectronique et est bien connue de l'homme du métier.

Pour trouver la température de cristallisation du matériau à évaluer on va soumettre le dispositif de test, c'est-à-dire les sondes en tungstène qui ont été mises en contact avec la couche à tester 20 de la tranche 710, à des températures croissantes. Comme montré sur la figure 11b on fait, par exemple, croître linéairement 720 la température du dispositif de 10°C par minute et on surveille la résistivité de la couche testée pendant toute la montée en température.

La figure 11c illustre un résultat typique de mesures effectuées dans les conditions ci-dessus. L'exemple de matériau testé dans cette figure est le matériau à changement de phase traditionnel c'est-à-dire le GST dont on sait que sa température de recristallisation est trop basse pour être utilisée dans le cadre de l'invention. On constate en effet sur la courbe 730 qui montre l'évolution décroissante de la résistivité en fonction de la température une baisse brutale 732 de celle-ci quand la recristallisation se produit. Cette température de recristallisation est comme on peut le voir de l'ordre de 150°C pour ce matériau.

Cet équipement de test permet un dépistage rapide de matériaux appropriés, c'est-à-dire ceux qui présentent une température de cristallisation suffisamment élevée pour supporter les températures maximales subies lors des étapes finales de fabrication (BEOL), soit typiquement 400°C pendant 2 minutes, en restant dans leur phase amorphe telle que déposée. Ces matériaux sont alors potentiellement aptes à résoudre le problème posé par la perte des informations préprogrammées lors du soudage par refusion en utilisant le procédé de préprogrammation de l'invention.

L'effet favorable de la couche de titane sur la température de recristallisation du matériau à changement de phase peut être évalué également avec cet équipement de test. Pour ce faire, on prépare une tranche de test 710 qui, comme montré sur la figure 11a, comprend aussi une couche de titane 25. Dans la tranche de test, la couche de titane 25 doit de manière préférée mais non limitative être située sous la couche du matériau à changement de phase 20 testé. Le positionnement de cette couche de titane en dessous de la couche de matériau à changement de phase permet notamment de limiter l'oxydation de la couche de titane. On retrouve aussi dans la tranche de test la couche d'oxyde de silicium (SiO2) 50 qui est déposée sur un support mécanique, par exemple une tranche ou substrat standard de silicium (Si) 712. L'empilement de couches d'une tranche de test 710 destinée à évaluer électriquement l'effet de la présence d'une couche de titane sur du GST comprend donc, par exemple, la couche de GST 20 d'une épaisseur de 100 nm sur la couche de titane 25 d'une épaisseur de 5 nm. Le tout est supporté par les couches Si/SiO2 d'une épaisseur globale de 500 nm.

La figure 11d montre d'autres résultats expérimentaux obtenus avec la méthode de l'invention où la transition cristalline 732 est clairement visible. Ces résultats concernant du GeTeC7% avec différentes épaisseurs de titane (sans titane pour comparaison, 2 nm, 5 nm et 10 nm). On constate comme précédemment l'influence de la présence d'une couche de titane, et de son épaisseur. La température de recristallisation dépasse 400°C avec une couche de titane de 10 nm satisfaisant ainsi le critère de sélection du matériau et garantissant qu'avec la structure correspondante le matériau restera dans l'état amorphe tel que déposé à l'issue des étapes de fin de ligne de fabrication (BEOL).

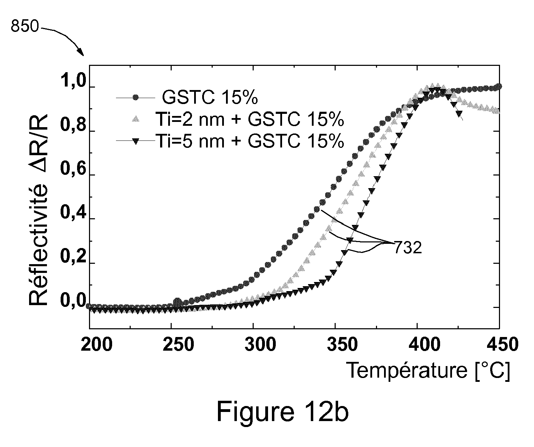

Les **figures 12a** **et** **12c** illustrent un autre moyen d'évaluer la température de recristallisation du matériau testé. Il est basé sur le changement de réflectivité optique de la couche de matériau à changement de phase lors de la transition vers la phase cristalline. En effet, la méthode électrique précédente fonctionne d'autant mieux que la résistivité de la couche dans la phase cristalline à mesurer est faible (et faible par rapport à celle de métal). La mesure n'est pas alors perturbée par les couches sous-jacentes. Quand c'est le cas, la transition cristalline 732 est clairement visible comme montré dans les exemples des figures 11c et 11 d. Dans le cas où la résistivité de la couche de matériau à changement de phase à mesurer est élevée on aura donc recours de préférence à la méthode optique illustrée par les figures 12a et 12b.

On notera que dans ce cas la tranche de test 710 est préparée avec la couche de titane 25 située au dessus de la couche de matériau à changement de phase 20 que l'on désire tester.

Les diagrammes de la figure 12a comparent les résultats des deux méthodes et concernent globalement trois matériaux à changement de phase. Les diagrammes 810 et 820 montrent les résultats obtenus avec, respectivement, la méthode optique de mesure de la réflectivité et la méthode électrique de mesure de la résistivité. Ces diagrammes concernent du GeTe non dopé 812 et du GeTeN 814, c'est-à-dire du GeTe dopé à l'azote (N). Sur l'exemple illustré, le dopage à l'azote est de 10% (mesure RBS) à plus ou moins un 1%. Les diagrammes 830 et 840, similaires aux diagrammes précédents concernent le matériau traditionnel, le GST. On voit qu'il y a un très bon accord entre les deux méthodes pour détecter la température de recristallisation du matériau testé. Dans les diagrammes 810 et 820 on remarque l'influence favorable du dopage à l'azote qui fait passer la température de recristallisation de 180 à 280°C. Valeur qui est toutefois insuffisante pour empêcher la recristallisation lors des étapes de BEOL.

Les équipements de test utilisés sont schématisés dans les inserts des diagrammes 830 et 840. Il s'agit, pour la mesure de la résistivité, du système électrique conventionnel à 4 pointes décrit dans la figure **11a****.** Pour la mesure de la réflectivité, on a recours à un appareillage optique classique 800 utilisant des lasers.

La figure 12b illustre le résultat de la mesure de la réflectivité optique sur un matériau, le GSTC15%, pour lequel la mesure de la résistivité ne fonctionne pas, en particulier en raison de la présence de la couche de titane sous-jacente qui vient court-circuiter la couche de ce matériau à changement de phase qui est électriquement très résistant dans sa phase amorphe et cristalline.

On détecte ici très bien les transitions cristallines 732 qui approchent les 400°C requis pour pouvoir passer les étapes de BEOL sans recristallisation. Comme précédemment on note l'influence très favorable de la présence d'une couche de titane, effet qui augmente avec l'épaisseur déposée (2 et 5 nm).

La présente invention s'avère particulièrement avantageuse dans tous les cas où les cellules mémoires sont susceptibles de subir de fortes contraintes thermiques après programmation. Ces contraintes thermiques ne sont pas limitées aux seules opérations d'assemblage.

L'invention n'est pas limitée aux modes de réalisation précédemment décrits est s'étend à tous modes de réalisation couverts par les revendications.

## Revendications

1. Procédé de réalisation d'un système comprenant au moins un dispositif mémoire incluant une pluralité de cellules mémoire (1) non volatiles comprenant chacune un matériau à changement de phase (22) configuré pour changer réversiblement d'état entre au moins un état amorphe et un état cristallin présentant des résistances électriques différentes, le procédé comprenant des étapes de fabrication des cellules mémoire (1), lesdites étapes de fabrication comprenant la formation d'une couche (20) en un matériau à changement de phase (22) présentant un état amorphe originel à l'issue des étapes de fabrication des cellules mémoire (1), et le procédé de réalisation du système embarqué comprenant, après les étapes de fabrication des cellules mémoire (1), au moins les étapes suivantes:
- une étape de préprogrammation (510) du dispositif mémoire consistant en une recristallisation électrique d'une sélection de cellules mémoire (1) dont le matériau à changement de phase est dans l'état amorphe originel ;
- une étape d'assemblage (520) du dispositif mémoire préprogrammé dans le système au cours duquel le dispositif est soumis à une température comprise entre 240°C et 300°C.

2. Procédé selon la revendication précédente dans lequel on choisit le matériau à changement de phase de manière à ce que la résistance la plus faible parmi les cellules mémoire dont le matériau à changement de phase est dans l'état amorphe originel est, après l'étape d'assemblage, au moins deux fois supérieure à la résistance la plus élevée parmi les cellules mémoire dont le matériau à changement de phase est dans l'état cristallin.

3. Procédé selon la revendication 1 ou 2 dans lequel le matériau à changement de phase (22) est une couche (20) faite d'un alliage de germanium (Ge), d'antimoine (Sb) et de tellure (Te) ou d'un alliage de germanium (Ge) et de tellure (Te), l'alliage étant additionné de carbone (C) dans lequel la proportion de carbone (C) dans l'alliage est comprise entre 1% en pourcentage molaire et 25% en pourcentage molaire.

4. Procédé selon la revendication 1 ou 2 dans lequel le matériau à changement de phase (22) est une couche (20) faite d'un alliage de germanium (Ge), d'antimoine (Sb) et de tellure (Te) ou d'un alliage de germanium (Ge) et de tellure (Te), l'alliage étant additionné d'indium (In) dans lequel la proportion d'indium (In) dans l'alliage est comprise entre 1% en pourcentage molaire et 25% en pourcentage molaire.

5. Procédé selon l'une quelconque des deux revendications précédentes dans lequel la couche (20) en un matériau à changement de phase (22) est couverte par une couche de titane (Ti) (25) dont l'épaisseur est comprise entre 3 et 10 nanomètres.

6. Procédé selon l'une quelconque des revendications précédentes dans lequel l'étape d'assemblage comprend une étape de brasage ou de soudage.

7. Procédé selon l'une quelconque des revendications précédentes comprenant, après l'étape d'assemblage (520), une étape de conversion (530), pour chaque cellule mémoire (1) du dispositif, de l'état amorphe originel ou de l'état cristallin préprogrammé en, respectivement : un état amorphe fonctionnel programmé électriquement à résistance élevé, ou en un état cristallin fonctionnel programmé électriquement à résistance faible.

8. Procédé selon l'une quelconque des revendications 1 à 6 comprenant, après l'étape d'assemblage (520), une étape de conversion (530), pour chaque cellule mémoire (1) du dispositif, de l'état amorphe originel ou de l'état cristallin préprogrammé en, respectivement : en un état cristallin fonctionnel programmé électriquement à résistance faible ou un état amorphe fonctionnel programmé électriquement à résistance élevé.

9. Procédé selon l'une quelconque des deux revendications précédentes dans lequel l'étape de conversion est exécutée sous le contrôle du dispositif à partir de circuits de lecture et d'écriture (330) des cellules mémoire (1), les dits circuits de lecture et d'écriture étant pourvus de moyens adaptés pour pouvoir différencier un état amorphe d'un état cristallin et, de préférence, la conversion (530) en un état cristallin fonctionnel programmé électriquement comprend un recuit électrique des cellules mémoire (1) de la sélection dont le matériau à changement de phase est dans l'état amorphe originel et, de préférence, comprenant en outre une étape de vérification (540) du système à l'aide d'un code préprogrammé.

10. Procédé selon l'une quelconque des trois revendications précédentes comprenant en outre une étape d'activation (550) d'un code fonctionnel préprogrammé.

11. Procédé selon l'une quelconque des revendications précédentes comprenant après les étapes de fabrication des cellules mémoire (1) et avant l'étape de d'assemblage du dispositif préprogrammé dans le système, une étape de montage des cellules mémoire (1) dans un boîtier, et dans lequel l'étape de montage des cellules mémoire (1) dans le boîtier est effectuée après l'étape de préprogrammation du dispositif ou est effectuée avant l'étape de préprogrammation du dispositif.

12. Procédé de programmation d'un système comprenant au moins un dispositif intégrant une pluralité de cellules mémoire (1) non volatile comprenant chacune un matériau à changement de phase (22) configuré pour changer réversiblement d'état entre au moins un état amorphe et un état cristallin présentant des résistances électriques différentes, le matériau à changement de phase (22) étant une couche (20) faite d'un alliage de germanium (Ge) et de tellure (Te) additionné de carbone (C) ou d'indium (In) ou étant faite d'un alliage de germanium (Ge), d'antimoine (Sb), de tellure (Te) additionné de carbone (C) ou d'indium (In) dans lequel la proportion de carbone (C) ou d'indium (In) dans l'alliage est comprise entre 1% en pourcentage molaire et 25% en pourcentage molaire ; la couche (20) en un matériau à changement de phase (22) étant couverte par une couche de titane (Ti) (25) dont l'épaisseur est comprise entre 3 et 10 nanomètres, la couche (20) en un matériau à changement de phase (22) présentant un état amorphe originel, ledit procédé de programmation du système comprenant, au moins les étapes suivantes:
- avant assemblage (520) du dispositif préprogrammé dans le système, une étape de préprogrammation (510) du dispositif consistant en une recristallisation électrique d'une sélection de cellules mémoire (1) dont le matériau à changement de phase est dans l'état amorphe originel;
- une étape d'assemblage (520) du dispositif préprogrammé dans le système.

13. Utilisation d'un système réalisé en mettant en oeuvre un procédé selon l'une quelconque des revendications 1 à 12 comme mémoire à lecture seule et à programmation unique.

14. Système réalisé en mettant en oeuvre un procédé selon l'une quelconque des revendications 1 à 12, dans lequel le dispositif forme une mémoire à lecture seule (ROM) ou une mémoire programmable à lecture seule (PROM) ou une mémoire programmable une seule fois (OTP).

15. Système selon la revendication précédente dans lequel le matériau à changement de phase (22) est une couche (20) faite d'un alliage de germanium (Ge) et de tellure (Te) additionné de carbone (C) ou d'indium (In) ou est faite d'un alliage de germanium (Ge), d'antimoine (Sb), de tellure (Te) additionné de carbone (C) ou d'indium (In) dans lequel la proportion de carbone (C) ou d'indium (In) dans l'alliage est comprise entre 1% en pourcentage molaire et 25% en pourcentage molaire et dans lequel la couche (20) matériau à changement de phase (22) étant couverte par une couche de titane (Ti) (25) dont l'épaisseur est comprise entre 3 et 10 nanomètres.

16. Système selon l'une quelconque des deux revendications précédentes dans lequel une partie des cellules mémoire (1) est dans un état amorphe originel et l'autre partie des cellules mémoire (1) est dans un état cristallin obtenu par recristallisation au moins partielle du matériau à changement de phase à partir de l'état amorphe originel et comprenant, de préférence, des circuits de lecture configurés pour lire les cellules mémoire et différencier les cellules mémoire se trouvant dans un état amorphe originel par rapport aux cellules mémoire se trouvant dans un état cristallin obtenu par recristallisation au moins partielle du matériau à changement de phase à partir de l'état amorphe originel.

17. Système selon la revendication précédente comprenant des circuits d'écriture des cellules mémoire (1) configurés pour convertir l'état amorphe originel en l'un parmi un état amorphe fonctionnel différent d'un état amorphe originel ou dans un état cristallin fonctionnel différent d'un état cristallin obtenu par recristallisation au moins partielle du matériau à changement de phase à partir de l'état amorphe originel et/ou et configurés pour convertir l'état cristallin obtenu à partir de l'état amorphe originel en l'autre parmi l'état amorphe fonctionnel et l'état cristallin fonctionnel.

## Patentansprüche

1. Verfahren zur Herstellung eines Systems, umfassend mindestens eine Speichervorrichtung, die eine Vielzahl von Permanent-Speicherzellen (1), umfassend jeweils ein Phasenwechselmaterial (22), das dazu vorgesehen ist, reversibel den Zustand zwischen mindestens einem amorphen Zustand und einem kristallinen Zustand, die unterschiedliche elektrische Widerstände aufweisen, zu wechseln, wobei das Verfahren Schritte zur Herstellung der Speicherzellen (1) umfasst, wobei die Herstellungsschritte die Bildung einer Schicht (20) aus einem Phasenwechselmaterial (22), das einen amorphen Originalzustand nach den Herstellungsschritten der Speicherzellen (1) aufweist, umfasst, und wobei das Verfahren zur Herstellung des eingebauten Systems nach den Herstellungsschritten der Speicherzellen (1) mindestens die folgenden Schritte umfasst:
- einen Schritt der Vorprogrammierung (510) der Speichervorrichtung, bestehend in einer elektrischen Rekristallisierung einer Auswahl von Speicherzellen (1), deren Phasenwechselmaterial im amorphen Originalzustand ist;
- einen Schritt des Einbaus (520) der vorprogrammierten Speichervorrichtung in das System, während dessen die Vorrichtung einer Temperatur zwischen 240°C und 300°C ausgesetzt wird.

2. Verfahren nach dem vorhergehenden Anspruch, bei dem das Phasenwechselmaterial derart ausgewählt ist, dass der geringste Widerstand unter den Speicherzellen, deren Phasenwechselmaterial in einem amorphen Originalzustand ist, nach dem Einbauschritt mindestens zweimal größer als der höchste Widerstand unter den Speicherzellen ist, deren Phasenwechselmaterial im kristallinen Zustand ist.

3. Verfahren nach Anspruch 1 oder 2, bei dem das Phasenwechselmaterial (22) eine Schicht (20) aus einer Legierung von Germanium (Ge), Antimon (Sb) und Tellur (Te) oder einer Legierung aus Germanium (Ge) und Tellur (Te) ist, wobei der Legierung Kohlenstoff (C) hinzugefügt ist, wobei der Kohlenstoffanteil (C) in der Legierung zwischen 1 Mol-% und 25 Mol-% beträgt.

4. Verfahren nach Anspruch 1 oder 2, bei dem das Phasenwechselmaterial (22) eine Schicht (20) aus einer Legierung aus Germanium (Ge), Antimon (Sb) und Tellur (Te) oder einer Legierung aus Germanium (Ge) und Tellur (Te) ist, wobei der Legierung Indium (In) hinzugefügt ist, wobei der Indiumanteil (In) in der Legierung zwischen 1 Mol-% und 25 Mol-% beträgt.

5. Verfahren nach einem der beiden vorhergehenden Ansprüche, bei dem die Schicht (20) aus einem Phasenwechselmaterial (22) mit einer Titanschicht (Ti) (25) bedeckt ist, deren Dicke zwischen 3 und 10 Nanometer beträgt.

6. Verfahren nach einem der vorhergehenden Ansprüche, bei dem der Einbauschritt einen Schritt des Lötens oder Schweißens umfasst.

7. Verfahren nach einem der vorhergehenden Ansprüche, umfassend nach dem Einbauschritt (520) für jede Speicherzelle (1) der Vorrichtung einen Umwandlungsschritt (530) vom amorphen Originalzustand oder vorprogrammierten kristallinen Zustand in: einen elektrisch programmierten amorphen Betriebszustand mit hohem Widerstand bzw. in einen elektrisch programmierten kristallinen Betriebszustand mit geringem Widerstand.

8. Verfahren nach einem der Ansprüche 1 bis 6, umfassend nach dem Einbauschritt (520) für jede Speicherzelle (1) der Vorrichtung einen Umwandlungsschritt (530) vom amorphen Originalzustand oder vorprogrammierten kristallinen Zustand in: einen elektrisch programmierten kristallinen Betriebszustand mit geringem Widerstand bzw. in einen elektrisch programmierten amorphen Betriebszustand mit hohem Widerstand.

9. Verfahren nach einem der beiden vorhergehenden Ansprüche, bei dem der Umwandlungsschritt unter der Kontrolle der Vorrichtung auf Basis von Lese- und Schreibschaltungen (330) der Speicherzellen (1) erfolgt, wobei die Lese- und Schreibschaltungen mit Mitteln versehen sind, die dazu vorgesehen sind, einen amorphen Zustand von einem kristallinen Zustand unterscheiden zu können, und bei dem vorzugsweise die Umwandlung (530) in einen elektrisch programmierten kristallinen Betriebszustand ein elektrisches Glühen der Speicherzellen (1) der Auswahl umfasst, deren Phasenwechselmaterial in dem amorphen Originalzustand ist, und vorzugsweise ferner umfassend einen Schritt der Überprüfung (540) des Systems mit Hilfe eines vorprogrammierten Codes.

10. Verfahren nach einem der drei vorhergehenden Ansprüche, ferner umfassend einen Schritt der Aktivierung (550) eines vorprogrammierten Betriebscodes.

11. Verfahren nach einem der vorhergehenden Ansprüche, umfassend nach den Schritten der Herstellung der Speicherzellen (1) und vor dem Einbauschritt der vorprogrammierten Vorrichtung in das System einen Schritt der Montage der Speicherzellen (1) in einem Gehäuse, und bei dem der Schritt der Montage der Speicherzellen (1) in dem Gehäuse nach dem Schritt der Vorprogrammierung der Vorrichtung oder vor dem Schritt der Vorprogrammierung der Vorrichtung erfolgt.

12. Verfahren zur Programmierung eines Systems, umfassend mindestens eine Vorrichtung, die eine Vielzahl von Permanent-Speicherzellen (1), umfassend jeweils ein Phasenwechselmaterial (22), das dazu vorgesehen ist, reversibel den Zustand zwischen mindestens einem amorphen Zustand und einem kristallinen Zustand, die unterschiedliche elektrische Widerstände aufweisen, zu wechseln, wobei das Phasenwechselmaterial (22) eine Schicht (20) ist, die aus einer Legierung aus Germanium (Ge) und Tellur (Te) unter Hinzufügung von Kohlenstoff (C) oder Indium (In) besteht oder aus einer Legierung aus Germanium (Ge), Antimon (Sb), Tellur (Te) unter Hinzufügung von Kohlenstoff (C) oder Indium (In) besteht, wobei der Anteil von Kohlenstoff (C) oder Indium (In) in der Legierung zwischen 1 Mol-% und 25 Mol-% beträgt; wobei die Schicht (20) aus einem Phasenwechselmaterial (22) mit einer Titanschicht (Ti) (25) bedeckt ist, deren Dicke zwischen 3 und 10 Nanometer beträgt, wobei die Schicht (20) aus einem Phasenwechselmaterial (22) einen amorphen Originalzustand aufweist, wobei das Verfahren zur Programmierung des Systems mindestens die folgenden Schritte aufweist:
- vor dem Einbau (520) der vorprogrammierten Vorrichtung in das System einen Schritt der Vorprogrammierung (510) der Vorrichtung, der in einer elektrischen Rekristallisierung einer Auswahl von Speicherzellen (1) besteht, deren Phasenwechselmaterial in dem amorphen Originalzustand ist;
- einen Einbauschritt (520) der vorprogrammierten Vorrichtung in das System.

13. Verwendung eines hergestellten Systems, das ein Verfahren nach einem der Ansprüche 1 bis 12 als Nur-Lesespeicher und mit einmaliger Programmierung einsetzt.

14. Hergestelltes Systems, das ein Verfahren nach einem der Ansprüche 1 bis 12 einsetzt, bei dem die Vorrichtung einen Nur-Lesespeicher (ROM) oder einen programmierbaren Nur-Lesespeicher (PROM) oder einen einmal programmierbaren Speicher (OTP) bildet.

15. System nach dem vorhergehenden Anspruch, bei dem das Phasenwechselmaterial (22) eine Schicht (20) aus einer Legierung aus Germanium (Ge) und Tellur (Te) unter Hinzufügung von Kohlenstoff (C) oder Indium (In) oder aus einer Legierung aus Germanium (Ge), Antimon (Sb), Tellur (Te) unter Hinzufügung von Kohlenstoff (C) oder Indium (In) ist, wobei der Anteil von Kohlenstoff (C) oder Indium (In) in der Legierung zwischen 1 Mol-% und 25 Mol-% beträgt, und bei dem die Schicht (20) aus Phasenwechselmaterial (22) mit einer Titanschicht (Ti) (25) bedeckt ist, deren Dicke zwischen 3 und 10 Nanometer beträgt.

16. System nach einem der beiden vorhergehenden Ansprüche, bei dem ein Teil der Speicherzellen (1) in einem amorphen Originalzustand ist, und der andere Teil der Speicherzellen (1) in einem kristallinen Zustand ist, der durch zumindest teilweise Rekristallisierung des Phasenwechselmaterials aus dem amorphen Originalzustand erhalten wird, und umfassend vorzugsweise Leseschaltungen, die dazu vorgesehen sind, dass sie die Speicherzellen lesen und die Speicherzellen, die sich in einem amorphen Originalzustand befinden, von den Speicherzellen unterscheiden, die sich in einem kristallinen Zustand befinden, der durch zumindest teilweise Rekristallisierung des Phasenwechselmaterials aus dem amorphen Originalzustand erhalten wird.

17. System nach dem vorhergehenden Anspruch, umfassend Schreibschaltungen der Speicherzellen (1), die dazu vorgesehen sind, den amorphen Originalzustand in einen unter einem zum amorphen Originalzustand unterschiedlichen amorphen Betriebszustand oder einen kristallinen Betriebszustand umzuwandeln, der sich von einem kristallinen Zustand unterscheidet, der durch zumindest teilweise Rekristallisation des Phasenwechselmaterials aus dem amorphen Originalzustand erhalten wird, und/oder die dazu vorgesehen sind, den aus dem amorphen Originalzustand erhaltenen kristallinen Zustand in den anderen unter dem amorphen Betriebszustand und dem kristallinen Betriebszustand umzuwandeln.

## Claims

1. Method for producing a system comprising at least one memory device including a plurality of non-volatile memory cells (1) each comprising a phase-change material (22) configured to change state reversibly between at least one amorphous state and a crystalline state having different electrical resistances, the method comprising steps for manufacturing the memory cells (1), the said steps for manufacturing comprising the formation of a layer (20) made of a phase-change material (22) exhibiting an original amorphous state at the end of the steps for manufacturing the memory cells (1), and the method for producing the embedded system comprising, after the steps for manufacturing the memory cells (1), at least the following steps:
- a step for pre-programming (510) the memory device consisting of electrical recrystallization of a selection of memory cells (1) the phase-change material of which is in the original amorphous state;
- a step for assembling (520) the pre-programmed memory device in the system in the course of which the device is subjected to a temperature of between 240°C and 300°C.

2. Method according to the preceding claim, in which the phase-change material is chosen such that the lowest resistance among the memory cells the phase-change material of which is in the original amorphous state is, after the step for assembling, at least two times greater than the highest resistance among the memory cells the phase-change material of which is in the crystalline state.

3. Method according to claim 1 or 2, in which the phase-change material (22) is a layer (20) made of an alloy of germanium (Ge), antimony (Sb) and tellurium (Te) or of an alloy of germanium (Ge) and tellurium (Te), the alloy having added carbon (C), in which the proportion of (C) in the alloy is between 1 % as a molar percentage and 25 % as a molar percentage.

4. Method according to claim 1 or 2, in which the phase-change material (22) is a layer (20) made of an alloy of germanium (Ge), antimony (Sb) and tellurium (Te) or of an alloy of germanium (Ge) and tellurium (Te), the alloy having added indium (In), in which the proportion of indium (In) in the alloy is between 1 % as a molar percentage and 25 % as a molar percentage.

5. Method according to any one of the preceding two claims, in which the layer (20) made of a phase-change material (22) is covered by a layer of titanium (Ti) (25) the thickness of which is between 3 and 10 nanometres.

6. Method according to any one of the preceding claims, in which the step for assembling comprises a brazing or soldering step.

7. Method according to any one of the preceding claims, comprising, after the step for assembling (520), a step for conversion (530), for each memory cell (1) of the device, of the original amorphous state or the pre-programmed crystalline state into respectively an electrically programmed functional amorphous state with a high resistance or an electrically programmed functional crystalline state with a low resistance.

8. Method according to any one of claims 1 to 6, comprising, after the step for assembling (520), a step for conversion (530), for each memory cell (1) of the device, of the original amorphous state or the pre-programmed crystalline state into respectively an electrically programmed functional crystalline state with a low resistance or an electrically programmed functional amorphous state with a high resistance.

9. Method according to any one of the preceding two claims, in which the step for conversion is executed under the control of the device using read and write circuits (330) of the memory cells (1), the said read and write circuits being provided with means which are adapted to be able to differentiate an amorphous state from a crystalline state, and preferably the conversion (530) into an electrically programmed functional crystalline state comprises electrical annealing of the memory cells (1) of the selection the phase-change material of which is in the original amorphous state, and preferably comprising in addition a step for checking (540) the system with the aid of a pre-programmed code.

10. Method according to any one of the preceding three claims, comprising in addition a step for activating (550) a pre-programmed functional code.

11. Method according to any one of the preceding claims, comprising, after the steps for manufacturing the memory cells (1) and before the step for assembling the pre-programmed device in the system, a step for mounting the memory cells (1) in a can, and in which the step for mounting the memory cells (1) in the can is performed after the step for pre-programming the device or is performed before the step for pre-programming the device.

12. Method for programming a system comprising at least one device integrating a plurality of non-volatile memory cells (1) each comprising a phase-change material (22) configured to change state reversibly between at least one amorphous state and a crystalline state having different electrical resistances, the phase-change material (22) being a layer (22) made of an alloy of germanium (Ge) and tellurium (Te) with added carbon (C) or indium (In) or being made of an alloy of germanium (Ge), antimony (Sb), tellurium (Te) with added carbon (C) or indium (In) in which the proportion of carbon (C) or indium (In) in the alloy is between 1 % as a molar percentage and 25 % as a molar percentage, the layer (20) made of a phase-change material (22) being covered by a layer of titanium (Ti) (25) the thickness of which is between 3 and 10 nanometres, the layer (20) made of a phase-change material (22) exhibiting an original amorphous state, the said method for programming the system comprising at least the following steps:
- before assembling (520) the pre-programmed device in the system, a step for pre-programming (510) the device consisting of electrical recrystallization of a selection of memory cells (1) the phase-change material of which is in the original amorphous state;
- a step for assembling (520) the pre-programmed device in the system.

13. Use of a system produced by implementing a method according to any one of claims 1 to 12, as a read-only memory which is programmable only once.

14. System produced by implementing a method according to any one of claims 1 to 12, in which the device forms a read-only memory (ROM) or a programmable read-only memory (PROM) or a memory which is programmable only once (OTP).

15. System according to the preceding claim, in which the phase-change material (22) is a layer (20) made of an alloy of germanium (Ge) and tellurium (Te) with added carbon (C) or indium (In) or is made of an alloy of germanium (Ge), antimony (Sb), tellurium (Te) with added carbon (C) or indium (In) in which the proportion of carbon (C) or indium (In) in the alloy is between 1 % as a molar percentage and 25 % as a molar percentage and in which the layer (20) made of phase-change material (22) is covered by a layer of titanium (Ti) (25) the thickness of which is between 3 and 10 nanometres.

16. System according to any one of the preceding two claims, in which one part of the memory cells (1) is in an original amorphous state and the other part of the memory cells (1) is in a crystalline state obtained by at least partial recrystallization of the phase-change material from the original amorphous state, and preferably comprising read circuits configured to read the memory cells and differentiate the memory cells in an original amorphous state from the memory cells in a crystalline state obtained by at least partial recrystallization of the phase-change material from the original amorphous state.

17. System according to the preceding claim, comprising write circuits for the memory cells (1) configured to convert the original amorphous state into one of a functional amorphous state different from an original amorphous state or a functional crystalline state different from a crystalline state obtained by at least partial recrystallization of the phase-change material from the original amorphous state and/or configured to convert the crystalline state obtained from the original amorphous state into the other of the functional amorphous state and the functional crystalline state.
